(19) **Europäisches Patentamt / European Patent Office / Office européen des brevets**

(11) **EP 3 291 411 B1**

(12) **EUROPÄISCHE PATENTSCHRIFT**

(45) Veröffentlichungstag und Bekanntmachung des Hinweises auf die Patenterteilung:
**08.05.2019 Patentblatt 2019/19**

(51) Int Cl.:
**H02J 9/06** (2006.01)

(21) Anmeldenummer: **16186872.4**

(22) Anmeldetag: **01.09.2016**

(54) **VERFAHREN ZUM STEUERN EINER UNTERBRECHUNGSFREIEN STROMVERSORGUNG UND ANLAGE FÜR EINE UNTERBRECHUNGSFREIE STROMVERSORGUNG**

METHOD FOR CONTROLLING AN UNINTERRUPTIBLE POWER SUPPLY AND INSTALLATION FOR AN UNINTERRUPTIBLE POWER SUPPLY

PROCEDE DE COMMANDE D'UNE ALIMENTATION ELECTRIQUE SECOURUE ET INSTALLATION POUR UNE ALIMENTATION ELECTRIQUE SECOURUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**07.03.2018 Patentblatt 2018/10**

(73) Patentinhaber: **Maschinenfabrik Reinhausen GmbH**
**93059 Regensburg (DE)**

(72) Erfinder:
• **GAVRILOV, Andrey**
**93051 Regensburg (DE)**
• **KRUSKA, Manfried**
**91074 Herzogenaurach (DE)**
• **REICH, Alexander**
**93098 Mintraching (DE)**

(56) Entgegenhaltungen:
**JP-A- 2003 259 567    US-A- 4 782 241**
**US-A- 5 210 685**

**Beschreibung**

Die Erfindung betrifft ein Verfahren zum Steuern einer unterbrechungsfreien Stromversorgung sowie eine Anlage für eine unterbrechungsfreie Stromversorgung.

Thyristoren sind bekanntlich Leistungshalbleiter, die in der Leistungselektronik für das Schalten hoher elektrischer Ströme und Spannungen ausgelegt sind. Üblicherweise werden in Zusammenhang mit einem Thyristor die folgenden Begriffe verwendet:

»Hauptspannung« ist die Spannung zwischen seiner Anode und seiner Kathode;

»Hauptstrom« ist der Strom durch die Kathode;

»Steuerspannung« ist die Spannung zwischen seinem Gate und der Kathode, sie ist positiv, wenn das Gate im Vergleich zu der Kathode das höhere Potenzial hat;

»Steuerstrom« ist der Strom durch das Gate;

»Zündstrom« ist ein in das Gate hinein fließender Steuerstrom, der Steuerstrom ist dann positiv;

»Löschstrom« ist ein aus dem Gate heraus fließender Steuerstrom, der Steuerstrom ist dann negativ;

»Vorwärtsrichtung« ist die Richtung von Anode zu Kathode;

»Vorwärtsspannung« ist die in Vorwärtsrichtung gepolte Hauptspannung, die Hauptspannung ist dann positiv;

»Vorwärtsstrom« ist der in Vorwärtsrichtung fließende Hauptstrom, der Hauptstrom ist dann positiv;

»Rückwärtsrichtung« ist die Richtung von Kathode zu Anode;

»Rückwärtsspannung« ist die in Rückwärtsrichtung gepolte Hauptspannung, die Hauptspannung ist dann negativ;

»Rückwärtsstrom« ist der in Rückwärtsrichtung fließende Hauptstrom, der Hauptstrom ist dann negativ;

»Sperrzustand« und »Durchlasszustand« sind die beiden stabilen Betriebszustände, die der Thyristor einnehmen kann, wenn ein Vorwärtsstrom fließt;

»Einraststrom«, »Haltestrom« und »Freiwerdezeit« sind charakteristische Kenngrößen des jeweiligen Thyristors und werden meist in seinem Datenblatt angegeben.

Ein Thyristor kann bekanntlich in den Durchlasszustand gebracht werden, was auch Zünden oder Einschalten genannt wird, indem eine Vorwärtsspannung angelegt wird und zumindest kurzzeitig, typischerweise für ungefähr 10 μs, eine positive Steuerspannung angelegt und ein Zündstrom erzeugt wird, bis der Vorwärtsstrom den Einraststrom überschreitet. Nun bleibt der Thyristor auch dann in dem Durchlasszustand, wenn der Steuerstrom erlischt oder gar umgepolt wird, allerdings nur, solange der Vorwärtsstrom den Haltestrom nicht unterschreitet und die Vorwärtsspannung anliegt.

Sobald allerdings die Hauptspannung umgepolt wird, sodass aus der Vorwärtsspannung eine Rückwärtsspannung wird, oder der Vorwärtsstrom den Haltestrom unterschreitet, geht der Thyristor in den Sperrzustand über, was auch Erlöschen oder Ausschalten oder Kommutieren genannt wird.

Normale Thyristoren, die auch als natürlich kommutierende Thyristoren bezeichnet werden, können bekanntlich nur auf die zuvor beschriebene Weise gelöscht werden, GTO-Thyristoren zusätzlich aber auch, indem ein Löschstrom erzeugt wird. Somit erlöschen normale Thyristoren üblicherweise frühestens dann, wenn der Hauptstrom den nächsten Nulldurchgang erreicht, wohingegen GTO-Thyristoren zu jedem beliebigen Zeitpunkt gelöscht werden können. Normale Thyristoren sind derzeit beispielsweise für Ströme bis 2,2 kA und mehr und für Spannungen bis 7 kV und mehr ausgelegt, wohingegen GTO-Thyristoren derzeit nur für niedrigere Ströme und Spannungen ausgelegt werden können und teurer sind.

EP 1 160 965 B1 beschreibt eine Anlage für eine unterbrechungsfreie Stromversorgung, die einen Eingang, der an eine Eingangsenergiequelle angeschlossen ist, und einen Ausgang umfasst, der an eine kritische Last angeschlossen ist. Diese bekannte Anlage umfasst zudem einen Versorgungstrennschalter, der zwei antiparallel geschaltete normale Thyristoren umfasst und zwischen den Eingang und einen Eingangsbus gekoppelt ist, einen Batteriebus, einen Wechselrichter, der zwischen den Batteriebus und den Ausgang gekoppelt ist, und eine Wechselrichtersteuerung. Bei einem Zusammenbruch der Eingangsspannung erzeugt der Wechselrichter am Eingangsbus eine Ausgleichsspannung, die für die unterbrechungsfreie Stromversorgung erforderlich ist, und diese Ausgleichsspannung führt in Kombination mit der abfallenden Eingangsspannung dazu, dass die Thyristoren des Versorgungstrennschalters automatisch kommutieren, da der Strom durch sie auf Null getrieben wird. Die Wechselrichtersteuerung steuert bei Feststellung eines Eingangsenergiequellenfehlers, der einen Anstieg des Betrags der Eingangsspannung verursacht, den Wechselrichter derart, dass er am Eingangsbus eine Spannung erzeugt, die die gleiche Polarität wie die Eingangsspannung und einen größeren Betrag als die Eingangsspannung hat, wodurch die Thyristoren des Versorgungstrennschalters gezwungen werden zu kommutieren.

EP 1 276 202 B1 beschreibt eine Anlage für eine unterbrechungsfreie Stromversorgung sowie ein Verfahren zur Steuerung einer solchen Anlage. Diese Anlage umfasst eine Wechselstromquelle zur Versorgung einer Last, eine Gleichstromquelle, einen Wechselrichter, der zwischen die Gleichstromquelle und die Last geschaltet ist, einen Wechselstromschalter, der zwei antiparallel geschaltete Thyristoren umfasst und zwischen die Wechselstromquelle und die Last bzw. den Wechselrichter geschaltet ist, einen Stromsensor für den Strom durch den Wechselstromschalter sowie eine Steuereinrichtung. Gemäß dem bekannten Verfahren wird, falls die Versorgungspannung der Wechselstromquelle ausfällt, der Wechselstromschalter geöffnet und mittels des Wechselrichters eine Ausgangsspannung erzeugt, die die Last versorgt. Die Steuereinrichtung kann hierzu eine Synchron-Sinusspannung, eine Hoch-Synchron-Sinusspannung und eine Nieder-Synchron-Spannung erzeugen und dem Wechselrichter als eine Referenzspannung zuführen. Die Synchron-Sinusspannung ist mit der Wechselstromquelle synchronisiert. Die Hoch-Synchron-Sinusspannung hat im Vergleich zu der Synchron-Sinusspannung die gleiche Phase und eine größere Amplitude. Die Nieder-Synchron-Sinusspannung hat im Vergleich zu der Synchron-Sinusspannung die gleiche Phase und eine kleinere Amplitude. Falls die Steuereinrichtung keinen Ausfall der Wechselstromquelle detektiert, so führt sie dem Wechselrichter die Synchron-Sinusspannung als Referenzspannung zu, woraufhin der Wechselrichter die Ausgangsspannung derart einstellt, dass sie im Vergleich zu der Spannung der Wechselstromquelle die gleiche Phase und die gleiche Amplitude hat. Falls die Steuereinrichtung einen Ausfall der Wechselstromquelle detektiert, so führt sie, falls der Stromsensor einen positiven Strom erfasst, dem Wechselrichter die Hoch-Synchron-Sinusspannung als Referenzspannung zu, woraufhin der Wechselrichter die Ausgangsspannung derart einstellt, dass sie im Vergleich zu der Spannung der Wechselstromquelle die gleiche Phase und eine größere Amplitude hat. Falls die Steuereinrichtung einen Ausfall der Wechselstromquelle detektiert, so führt sie, falls der Stromsensor einen negativen Strom erfasst, dem Wechselrichter die Nieder-Hoch-Synchron-Sinusspannung als Referenzspannung zu, woraufhin der Wechselrichter die Ausgangsspannung derart einstellt, dass sie im Vergleich zu der Spannung der Wechselstromquelle die gleiche Phase und eine kleinere Amplitude hat. Falls die Steuereinrichtung einen Ausfall der Wechselstromquelle detektiert, so führt sie, falls der Stromsensor einen Strom gleich Null erfasst, dem Wechselrichter die Synchron-Sinusspannung als Referenzspannung zu.

Dokument US 5 210 685 A beschreibt in Figur 4 ein System zur unterbrechungsfreien Stromversorgung. Zwei antiparallel geschaltete Thyristoren THA1p und THA1n sind zwischen einer Wechselspannungsquelle und einem Verbraucher geschaltet. Ein Inverter ist eingangseitig mit einem Kondensator und ausgangsseitig zwischen den Thyristoren und dem Verbraucher verbunden. Das System dient dazu, eine Last von einer Primärquelle auf eine Ersatzquelle umzuschalten. Dabei bleibt die Ersatzquelle während des konventionellen Kommutationsbetriebs geladen.

Dokument US 4 782 241 A befasst sich ebenfalls mit einem System zur unterbrechungslosen Stromversorgung. Im Falle einer plötzlichen Phasenabweichung im Schalterstrom wird die Richtung des Schalterstroms ausgewertet um basierend darauf einen Inverter zur Ersatzstromversorgung einzusetzen.

Dokument JP 2003 259567 A betrifft ebenfalls ein System zur unterbrechungslosen Stromversorgung. Das System umfasst ein paar antiparallel geschalteter Thyristoren und einen Parallelumrichter um eine Batterie zu laden sowie einen Reihenumrichter zur Ersatzversorgung. Zwischen den Thyristoren und dem Ausgang des Systems ist ein Transformator angeordnet um die Ausgangsspannung an die Last anzupassen. Dadurch kann ein plötzlicher Spannungsabfall an der Last vermieden werden.

Vor diesem Hintergrund schlägt die Erfindung die Gegenstände der unabhängigen Ansprüche vor. Vorteilhafte Ausführungsformen der Erfindung sind in den abhängigen Ansprüchen beschrieben.

Im Folgenden entspricht eine Formulierung der Art "A ist an B angebunden" einer Formulierung der Art "A ist mit B verbunden", umfasst eine Formulierung der Art "A ist mit B verbunden" die Bedeutungen "A ist direkt mit B elektrisch leitend verbunden" und "A ist indirekt, also über C, mit B elektrisch leitend verbunden", und hat eine Formulierung der Art "A ist an B angeschlossen" die Bedeutung "A ist direkt mit B elektrisch leitend verbunden". Die Erfindung schlägt gemäß einem ersten Aspekt ein Verfahren zum Steuern einer unterbrechungsfreien Stromversorgung mithilfe einer Anlage für eine unterbrechungsfreie Stromversorgung vor, wobei die Anlage umfasst

- eine erste Anschlussklemme, die mit einer Wechselstromquelle verbunden werden kann;
- eine zweite Anschlussklemme, die mit einem Wechselstromverbraucher verbunden werden kann;
- einen Schalter, umfassend

    • eine erste Schalterklemme, die mit der ersten Anschlussklemme verbunden ist;
    • eine zweite Schalterklemme, die mit der zweiten Anschlussklemme verbunden ist;
    • einen ersten Thyristor, der zwischen die Schalterklemmen geschaltet ist;
    • einen zweiten Thyristor, der antiparallel zu dem ersten Thyristor zwischen die Schalterklemmen geschaltet ist;

- einen Energiespeicher;
- einen Wechselrichter, der mit der zweiten Anschlussklemme und dem Energiespeicher verbunden ist;
  wobei
- ein Schalterstrom erfasst wird, der durch den Schalter fließt;
- ein erstes Potenzial erfasst wird, das an der ersten Anschlussklemme anliegt;
- in einem ersten Fehlerfall, in dem der Betrag des ersten Potenzials sinkt, so dass der Momentanwert des ersten Potentials eine erste vorgegebene Zulässigkeitsregel verletzt und der Betrag des Schalterstroms steigt, so dass der Momentanwert des Schalterstroms eine zweite vorgegebene Zulässigkeitsregel verletzt

- mithilfe des Wechselrichters ein zweites Potenzial, das an der zweiten Schalterklemme anliegt, so eingestellt wird, dass der Schalterstrom auf Null getrieben wird;
- nach dem Einstellen des zweiten Potenzials der Schalterstrom überprüft wird, indem

  - der Betrag des Schalterstroms bis zu einem vorgegebenen ersten Prüfzeitpunkt, der nach dem Einstellen des zweiten Potenzials liegt, erfasst und mit einem vorgegebenen Schwellenwert verglichen wird und bei Überschreitung dieses Schwellenwertes ein erstes Prüfergebnis als positiv und andernfalls als negativ gewertet wird;
  - bei positivem ersten Prüfergebnis das zweite Potenzial umgekehrt wird;
  - bei negativem ersten Prüfergebnis der Schalterstrom zu einem vorgegebenen zweiten Prüfzeitpunkt, der bei oder nach dem ersten Prüfzeitpunkt liegt, erfasst und mit Null verglichen wird und bei Abweichung von Null ein zweites Prüfergebnis als positiv und andernfalls als negativ gewertet wird;
  - bei positivem zweiten Prüfergebnis das zweite Potenzial umgekehrt wird.

Die Erfindung schlägt gemäß einem zweiten Aspekt eine Anlage für eine unterbrechungsfreie Stromversorgung vor, umfassend

- eine erste Anschlussklemme, die mit einer Wechselstromquelle verbunden werden kann;
- eine zweite Anschlussklemme, die mit einem Wechselstromverbraucher verbunden werden kann;
- einen Schalter, umfassend

  - eine erste Schalterklemme, die mit der ersten Anschlussklemme verbunden ist;
  - eine zweite Schalterklemme, die mit der zweiten Anschlussklemme verbunden ist;
  - einen ersten Thyristor, der zwischen die Schalterklemmen geschaltet ist;
  - einen zweiten Thyristor, der antiparallel zu dem ersten Thyristor zwischen die Schalterklemmen geschaltet ist;

- einen Energiespeicher;
- einen Wechselrichter, der mit der zweiten Anschlussklemme und dem Energiespeicher verbunden ist;
- einen Stromsensor, der einen Schalterstrom erfassen kann, der durch den Schalter fließt;
- einen ersten Spannungssensor, der ein erstes Potenzial erfassen kann, das an der ersten Anschlussklemme anliegt;
- eine Steuereinrichtung, die an den Schalter, den Wechselrichter und die Sensoren gekoppelt ist; wobei die Steuereinrichtung derart ausgebildet ist, dass sie
- den Schalterstrom und das erste Potenzial auswerten kann;
- einen ersten Fehlerfall erkennen kann, in dem der Betrag des ersten Potenzials sinkt, so dass der Momentanwert des ersten Potentials eine erste vorgegebene Zulässigkeitsregel verletzt und der Betrag des Schalterstroms steigt, so dass der Momentanwert des Schalterstroms eine zweite vorgegebene Zulässigkeitsregel verletzt, und sie in diesem Fall

  - den Wechselrichter derart ansteuert, dass er ein zweites Potenzial erzeugt, das an der zweiten Schalterklemme anliegt und den Schalterstrom auf Null treibt;
  - nach dem Einstellen des zweiten Potenzials den Schalterstrom überprüft, indem sie

    - den Betrag des Schalterstroms bis zu einem vorgegebenen ersten Prüfzeitpunkt, der nach dem Einstellen des zweiten Potenzials liegt, mit einem vorgegebenen Schwellenwert vergleicht und bei Überschreitung dieses Schwellenwertes ein erstes Prüfergebnis als positiv und andernfalls als negativ wertet;
    - bei positivem ersten Prüfergebnis das zweite Potenzial umkehrt;
    - bei negativem ersten Prüfergebnis den Schalterstrom zu einem vorgegebenen zweiten Prüfzeitpunkt, der bei oder nach dem ersten Prüfzeitpunkt liegt, mit Null vergleicht und bei Abweichung von Null ein zweites Prüfergebnis als positiv und andernfalls als negativ wertet;
    - bei positivem zweiten Prüfergebnis das zweite Potenzial umkehrt.

Die Erfindung ermöglicht ein schnelles Erlöschen oder Ausschalten oder Kommutieren der Thyristoren und damit ein schnelles Öffnen des Schalters selbst für den Fall, dass die Thyristoren normale Thyristoren sind, da das zweite Potenzial derart gewählt ist, dass der Schalterstrom auf Null getrieben wird und sein Betrag auf Null sinkt. Für den Fall, dass dieser Betrag nicht wie gewünscht bereits nach Anlegen des zweiten Potenzials auf Null sinken sollte, wird das angelegte zweite Potenzial umgekehrt, was dazu führt, dass der Schalterstrom spätestens hierdurch auf Null getrieben wird. Somit kann anschließend die unterbrechungsfreie Stromversorgung möglichst schnell gestartet werden. Der erwähnte Fall, dass der Betrag des Schalterstroms nicht auf Null sinkt, kann beispielsweise auftreten, wenn das Vorzeichen des Schalterstroms aufgrund hoher Latenzzeiten oder Ungenauigkeit bei der Messung falsch bestimmt wird oder unerwartet wechselt.

Im Sinne der Erfindung soll das Sinken einer Größe, wie beispielsweise das Sinken des Betrags des ersten Potenzials, »unzulässig« sein, wenn der Momentanwert dieser Größe eine vorgegebene Zulässigkeitsregel verletzt, und andernfalls »zulässig« sein. Diese Zulässigkeitsregel kann beispielsweise vorschreiben, dass der Momentanwert über einem vorgegebenen Schwellenwert liegen muss, und/oder dass die zeitliche Ableitung des Momentanwerts über einem vorgegebenen Schwellenwert liegen muss. Im Sinne der Erfindung soll das Steigen einer Größe, wie beispielsweise das Steigen des Betrags des Schalterstroms, »unzulässig« sein, wenn der Momentanwert dieser Größe eine vorgegebene Zulässigkeitsregel verletzt, und andernfalls »zulässig« sein. Diese Zulässigkeitsregel kann beispielsweise vorschreiben, dass der Momentanwert unter einem vorgegebenen Schwellenwert liegen muss, und/oder dass die zeitliche Ableitung des Momentanwerts unter einem vorgegebenen Schwellenwert liegen muss. Jeder Schwellenwert kann nach Bedarf konstant oder variabel sein.

Im Sinne der Erfindung soll die Überprüfung des Schalterstroms nach Einstellen des zweiten Potenzials den Vergleich des Schalterstroms mit einem vorgegebenen Schwellenwert und/oder die Überprüfung zu einem vorgegebenen Prüfzeitpunkt, ob der Schalterstrom von Null abweicht, umfassen. Wird somit zu einem beliebigen Zeitpunkt nach Einstellen des zweiten Potenzials der Schwellenwert überschritten und/oder weicht der Schalterstrom zu dem Prüfzeitpunkt nach Einstellen des zweiten Potenzials von Null ab, ist die Überprüfung als positiv zu werten.

Als Anlagenvorwärtsrichtung wird nachfolgend die Richtung von der ersten zu der zweiten Anschlussklemme bezeichnet, als Anlagenrückwärtsrichtung die Richtung von der zweiten zu der ersten Anschlussklemme.

Die Anlage des vorgeschlagenen Verfahrens und die vorgeschlagene Anlage können nach Bedarf auf beliebige Art und Weise ausgebildet sein und/oder beispielsweise keinen oder wenigstens einen zusätzlichen Schalter und/oder keinen oder wenigstens einen zusätzlichen Energiespeicher und/oder keinen oder wenigstens einen zusätzlichen Wechselrichter und/oder keinen oder wenigstens einen zusätzlichen Stromsensor und/oder keinen oder wenigstens einen zusätzlichen Spannungssensor und/oder keine oder wenigstens eine zusätzliche Steuereinrichtung umfassen.

Jeder Schalter kann nach Bedarf auf beliebige Art und Weise ausgebildet sein und/oder beispielsweise keinen oder wenigstens einen zusätzlichen Thyristor umfassen.

Die Thyristoren sind beispielhaft derart geschaltet, dass die Vorwärtsrichtung des ersten Thyristors von der ersten zu der zweiten Anschlussklemme oder von der ersten zu der zweiten Schalterklemme weist und die Vorwärtsrichtung des zweiten Thyristors von der zweiten zu der ersten Anschlussklemme oder von der zweiten zu der ersten Schalterklemme weist.

Jeder Thyristoren kann nach Bedarf auf beliebige Art und Weise ausgebildet sein, beispielsweise als normaler Thyristor oder als GTO-Thyristor oder als Lichtgezündeter Thyristor.

Jeder Energiespeicher kann nach Bedarf auf beliebige Art und Weise ausgebildet sein und/oder beispielsweise wenigstens einen Akkumulator und/oder wenigstens einen Kondensator umfassen.

Die Wechselstromquelle ist beispielhaft ein Wechselstromnetz. Der Wechselstromverbraucher ist beispielhaft ein Wechselstromnetz oder eine Fabrik, die Halbleiter oder Halbleiterprodukte oder Glas oder Glaswaren oder Kunststoff oder Kunststoffwaren produziert.

Es kann spezifiziert sein, dass

- in dem ersten Fehlerfall

  • das Einstellen des zweiten Potenzials derart erfolgt, dass
    $\text{sgn}(iS) \cdot v1 \le \text{sgn}(iS) \cdot v2$, insbesondere $\text{sgn}(iS) \cdot v1 < \text{sgn}(iS) \cdot v2$
    oder
    $-v2/v1 \ge 1$, insbesondere $-v2/v1 > 1$
    gilt; und/oder

- die Steuereinrichtung derart ausgebildet ist, dass sie in dem ersten Fehlerfall

  • den Wechselrichters derart ansteuert, dass für das zweite Potenzial
    $\text{sgn}(iS) \cdot v1 \le \text{sgn}(iS) \cdot v2$, insbesondere $\text{sgn}(iS) \cdot v1 < \text{sgn}(iS) \cdot v2$
    oder
    $-v2/v1 \ge 1$, insbesondere $-v2/v1 > 1$
    gilt,

worin v1 der Momentanwert des ersten Potenzials ist, v2 der Momentanwert des zweiten Potenzials ist, und iS der Momentanwert des Schalterstroms ist.

Es kann spezifiziert sein, dass

- das Umkehren gemäß folgender Formel erfolgt:

$$v2(t2) = -A1 \cdot v2(t1)$$

mit $A1 \ge 1$ und $t2 > t1$
worin v2 der Momentanwert des zweiten Potenzials ist, t2 ein Zeitpunkt ist, der nach dem Umkehren liegt, t1 ein Zeitpunkt ist, der vor dem Umkehren liegt, und A1 ein erster Anteilsfaktor ist.

Vorzugsweise ist A1 größer gleich 1,05 oder größer gleich 1,1 oder größer gleich 1,15 oder größer gleich 1,2 oder größer gleich 1,25 oder größer gleich 1,3 oder größer gleich 1,35.

Der vorgegebene Schwellenwert für den Schalterstrom liegt vorzugsweise im Bereich des 1,5 bis 2-fachen des Nennstroms der Anlage. Dieser Wert kann jedoch bauteilbedingt auch andere Werte, wie etwa das 1-fache, das 3-fache oder das 4-fache des Nennstroms der Anlage betragen.

Es kann spezifiziert sein, dass

- für den vorgegebenen zweiten Prüfzeitpunkt

$$PZ2 = T3 + A2 \cdot tq$$

mit $A2 \geq 1$
gilt, worin PZ2 der zweite Prüfzeitpunkt ist, T3 der Zeitpunkt ist, zu dem das zweite Potenzial eingestellt worden ist, A2 ein zweiter Anteilsfaktor ist, und tq die Freiwerdezeit der Thyristoren ist.

Vorzugsweise ist A2 größer gleich 1,05 oder größer gleich 1,1 oder größer gleich 1,15 oder größer gleich 1,2 oder größer gleich 1,25 oder größer gleich 1,3 oder größer gleich 1,35 oder größer gleich 2 oder größer gleich 3 oder größer gleich 4 oder größer gleich 5.

Es kann spezifiziert sein, dass

- nach dem Umkehren

$$v2 = sgn(iS) \cdot v0$$

mit $v0 > 0$
gilt, worin v0 ein vorgegebenes Vorgabepotenzial ist, v2 der Momentanwert des zweiten Potenzials ist, und iS der Momentanwert des Schalterstroms ist.

Das Vorgabepotenzial ist beispielhaft konstant oder variabel oder zeitlich variabel. Das Vorgabepotenzial wird bevorzugt derart gewählt, dass der Betrag des Schalterstroms auf Null sinkt.

Es kann spezifiziert sein, dass

- das Vorgabepotenzial zumindest zeitweise derart gewählt wird, dass

$$v0 = A3 \cdot VWR$$

mit $0 < A3 \leq 1$
gilt; und/oder
- die Steuereinrichtung derart ausgebildet ist, dass sie das Vorgabepotenzial zumindest zeitweise derart wählt, dass

$$v0 = A3 \cdot VWR$$

mit $0 < A3 \leq 1$
gilt,
worin A3 ein dritter Anteilsfaktor ist, und VWR das Nennpotenzial des Wechselrichters ist.

Der dritte Anteilsfaktor ist beispielhaft konstant oder variabel oder zeitlich variabel oder mit der Zeit monoton fallend.

Vorzugsweise ist A3 kleiner gleich 0,95 oder kleiner gleich 0,9 oder kleiner gleich 0,85 oder kleiner gleich 0,8 oder kleiner gleich 0,75 oder kleiner gleich 0,7 oder kleiner gleich 0,65 oder kleiner gleich 0,6 oder kleiner gleich 0,55.

Es kann spezifiziert sein, dass

- das Vorgabepotenzial zumindest zeitweise derart gewählt wird, dass

$$v0 = v(iS)$$

gilt; und/oder
- die Steuereinrichtung derart ausgebildet ist, dass sie das Vorgabepotenzial zumindest zeitweise derart wählt, dass

$$v0 = v(iS)$$

gilt,
worin v(iS) eine von dem Schalterstrom abhängige Funktion ist.

Es kann spezifiziert sein, dass

- die Funktion derart gewählt wird, dass

$$v(iS) = L \cdot d|iS|/dt$$

gilt; und/oder
- die Steuereinrichtung derart ausgebildet ist, dass sie die Funktion derart wählt, dass

$$v(iS) = L \cdot d|iS|/dt$$

gilt,
worin L die Induktivität der Wechselstromquelle und des Abschnitts der Anlage zwischen der ersten Anschlussklemme und der zweiten Schalterklemme ist, und d|iS|/dt die zeitliche Ableitung des Betrags des Schalterstroms ist.

Es kann spezifiziert sein, dass

Es kann spezifiziert sein, dass

- das Vorgabepotenzial zumindest zeitweise durch eine durch den Schalterstrom geführte Regelung ermittelt wird; und/oder
- die Steuereinrichtung derart ausgebildet ist, dass sie das Vorgabepotenzial zumindest zeitweise durch eine durch den Schalterstrom geführte Regelung ermitteln kann.

Es kann spezifiziert sein, dass

- überwacht wird, ob der Betrag des Schalterstroms nach dem Umkehren auf Null gesunken ist;
- sobald der Betrag des Schalterstroms auf Null gesunken ist, eine Wartezeit abgewartet wird, für die

$$TW = A4 \cdot tq$$

mit A4 ≥ 1
gilt, worin TW die Wartezeit ist, A4 ein vierter Anteilsfaktor ist, und tq die Freiwerdezeit der Thyristoren ist;
- nach Ablauf der Wartezeit mithilfe des Wechselrichters das zweite Potenzial so, wie es für eine unterbrechungsfreie Stromversorgung erforderlich ist, eingestellt wird und/oder mithilfe des Wechselrichters eine Wirkleistung, die für eine unterbrechungsfreie Stromversorgung erforderlich ist, und/oder eine Blindleistung, die für eine unterbrechungsfreie Stromversorgung erforderlich ist, erzeugt wird.

Es kann spezifiziert sein, dass die Steuereinrichtung derart ausgebildet ist, dass sie

- überwachen und/oder erkennen kann, ob der Betrag des Schalterstroms nach dem Umkehren auf Null gesunken ist;
- sobald der Betrag des Schalterstroms auf Null gesunken ist, eine Wartezeit abwartet, für die

$$TW = A4 \cdot tq$$

mit A4 ≥ 1
gilt, worin TW die Wartezeit ist, A4 ein vierter Anteilsfaktor ist, und tq die Freiwerdezeit der Thyristoren ist;
- nach Ablauf der Wartezeit den Wechselrichter derart ansteuert, dass er das zweite Potenzial so, wie es für eine unterbrechungsfreie Stromversorgung erforderlich ist, einstellt und/oder eine Wirkleistung, die für eine unterbrechungsfreie Stromversorgung erforderlich ist, und/oder eine Blindleistung, die für eine unterbrechungsfreie Stromversorgung erforderlich ist, erzeugt.

Dieses Abwarten verhindert ein Wiederzünden des soeben erloschenen Thyristors.
Vorzugsweise ist A4 größer gleich 1,05 oder größer gleich 1,1 oder größer gleich 1,15 oder größer gleich 1,2 oder größer gleich 1,3 oder größer gleich 1,4 oder größer gleich 1,6 oder größer gleich 1,8 oder größer gleich 2 oder größer gleich 2,5 oder größer gleich 3.
Es kann spezifiziert sein, dass

- in einem zweiten Fehlerfall, in dem der Betrag des ersten Potenzials unzulässig sinkt und der Betrag des Schalterstroms sinkt, und/oder in einem Schwankungsfall, in dem der Betrag des ersten Potenzials zulässig steigt oder zulässig sinkt, mithilfe des Wechselrichters

  • das zweite Potenzial so, wie es für eine unterbrechungsfreie Stromversorgung erforderlich ist, eingestellt wird; und/oder
  • eine Wirkleistung, die für eine unterbrechungsfreie Stromversorgung erforderlich ist, und/oder eine Blindleistung, die für eine unterbrechungsfreie Stromversorgung erforderlich ist, erzeugt wird.

Es kann spezifiziert sein, dass die Steuereinrichtung derart ausgebildet ist, dass sie

- einen zweiten Fehlerfall erkennen kann, in dem der Betrag des ersten Potenzials unzulässig sinkt und der Betrag des Schalterstroms sinkt, und/oder einen Schwankungsfall erkennen kann, in dem der Betrag des ersten Potenzials zulässig steigt oder zulässig sinkt, und in jedem dieser Fälle den Wechselrichter derart ansteuert, dass er

  • das zweite Potenzial so, wie es für eine unterbrechungsfreie Stromversorgung erforderlich ist, einstellt; und/oder
  • eine Wirkleistung, die für eine unterbrechungsfreie Stromversorgung erforderlich ist, und/oder eine Blindleistung, die für eine unterbrechungsfreie Stromversorgung erforderlich ist, erzeugt.

Es kann spezifiziert sein, dass

- in dem ersten und/oder zweiten Fehlerfall den Thyristoren kein Zündstrom zugeführt wird, und/oder
- die Steuereinrichtung derart ausgebildet ist, dass sie in dem ersten und/oder zweiten Fehlerfall den Thyristoren keinen Zündstrom zuführt.

Es kann spezifiziert sein, dass

- das zweite Potenzial erfasst wird;
- der Wechselrichter mithilfe des zweiten Potenzials und/oder in Abhängigkeit von dem zweiten Potenzial geregelt und/oder gesteuert wird.

Es kann spezifiziert sein, dass die Anlage umfasst

- einen zweiten Spannungssensor, der das zweite Potenzial erfassen kann und an die Steuereinrichtung gekoppelt ist;
- die Steuereinrichtung derart ausgebildet ist, dass sie

  • den Wechselrichter mithilfe des zweiten Potenzials und/oder in Abhängigkeit von dem zweiten Potenzial regelt und/oder steuert.

Es kann spezifiziert sein, dass

- der Wechselrichter bidirektional ausgebildet ist; oder
- ein Gleichrichter parallel zu dem Wechselrichter geschaltet und insbesondere an die Steuereinrichtung gekoppelt ist.

Mit einem derartigen Wechselrichter oder mit diesem Gleichrichter kann der Energiespeicher aufgeladen werden.

Es kann spezifiziert sein, dass die Anlage umfasst

- wenigstens eine Spule, die zwischen die erste Anschlussklemme und die erste Schalterklemme oder zwischen die zweite Schalterklemme und die zweite Anschlussklemme geschaltet ist; und/oder
- wenigstens einen Kondensator, der zwischen die erste Anschlussklemme und Masse oder zwischen die erste Schalterklemme und Masse oder zwischen die zweite Schalterklemme und Masse oder zwischen die zweite Anschlussklemme und Masse geschaltet ist; und/oder
- wenigstens einen Transformator, der zwischen den Wechselrichter und die zweite Schalterklemme oder zwischen den Wechselrichter und die zweite Anschlussklemme geschaltet ist.

Vorzugsweise ist die Reaktanz und/oder Impedanz der Spule so gewählt, dass sie der maximal möglichen Reaktanz und/oder Impedanz der Wechselstromquelle entspricht.

Es kann spezifiziert sein, dass jede der vorgeschlagenen Anlagen derart ausgebildet ist und/oder dazu dient und/oder dafür geeignet ist, dass sie

- eines der vorgeschlagenen Verfahren ausführt und/oder ausführen kann; und/oder
- die Anlage eines der vorgeschlagenen Verfahren bildet.

Mit jeder der vorgeschlagenen Anlagen kann beispielhaft eines der vorgeschlagenen Verfahren durchgeführt werden.

Die Ausführungen und Erläuterungen zu einem der Aspekte der Erfindung, insbesondere zu einzelnen Merkmalen dieses Aspektes, gelten entsprechend auch analog für die anderen Aspekte der Erfindung.

Im Folgenden werden Ausführungsformen der Erfindung beispielhaft anhand der beigefügten Zeichnungen näher erläutert. Die daraus hervorgehenden einzelnen Merkmale sind jedoch nicht auf die einzelnen Ausführungsformen beschränkt, sondern können mit weiter oben beschriebenen einzelnen Merkmalen und/oder mit einzelnen Merkmalen anderer Ausführungsformen verbunden und/oder kombiniert werden. Die Einzelheiten in den Zeichnungen sind nur erläuternd, nicht aber beschränkend auszulegen. Die in den Ansprüchen enthaltenen Bezugszeichen sollen den Schutzbereich der Erfindung in keiner Weise beschränken, sondern verweisen lediglich auf die in den Zeichnungen gezeigten Ausführungsformen.

Die Zeichnungen zeigen in

FIG. 1 eine erste Ausführungsform einer Anlage für eine unterbrechungsfreie Stromversorgung;

FIG. 2 eine zweite Ausführungsform der Anlage;

FIG. 3a einen zeitlichen Verlauf von Potenzialen in der Anlage der FIG. 2, wobei die Anlage gemäß einer bevorzugten Ausführungsform eines Verfahrens zum Steuern einer unterbrechungsfreien Stromversorgung gesteuert wird;

FIG. 3b einen mit FIG. 3a synchronisierten zeitlichen Verlauf des Stroms durch den Schalter der Anlage für den Fall, dass der Strom dem Potenzial nacheilt;

FIG. 3c einen mit FIG. 3a synchronisierten zeitlichen Verlauf des Stroms für den Fall, dass der Strom dem Potenzial weniger nacheilt;

FIG. 4a einen ersten zeitlichen Verlauf von Potenzialen in der Anlage der FIG. 2, wobei die Anlage gemäß der bevorzugten Ausführungsform des Verfahrens gesteuert wird;

FIG. 4b einen mit FIG. 4a synchronisierten zeitlichen Verlauf des Stroms;

FIG. 5a einen zweiten zeitlichen Verlauf von Potenzialen in der Anlage der FIG. 2, wobei die Anlage gemäß der bevorzugten Ausführungsform des Verfahrens gesteuert wird;

FIG. 5b einen mit FIG. 5a synchronisierten zeitlichen Verlauf des Stroms.

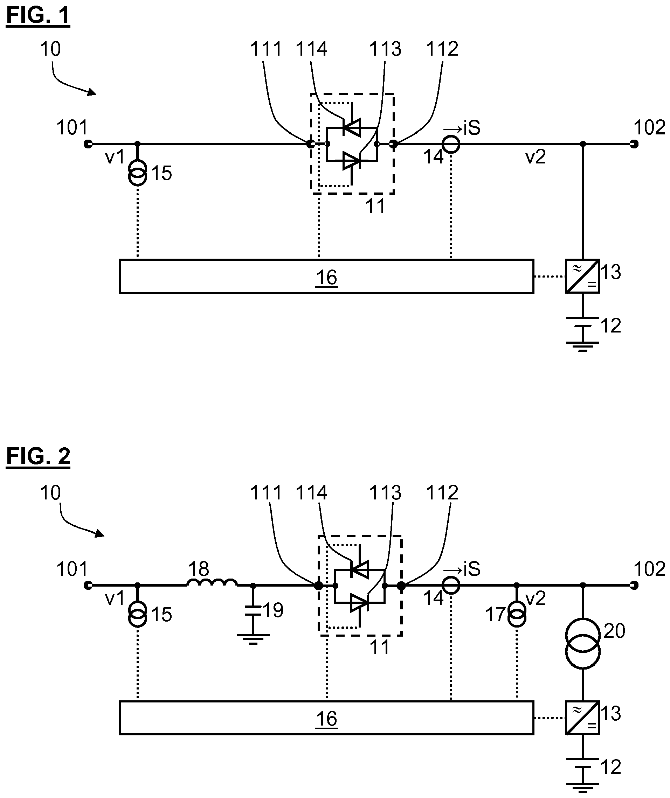

In FIG. 1 ist eine erste Ausführungsform einer elektrischen Anlage 10 für eine unterbrechungsfreie Stromversorgung schematisch dargestellt. Die Anlage 10 hat eine erste Anschlussklemme 101, die mit einer Wechselstromquelle (nicht dargestellt) verbunden ist, und eine zweite Anschlussklemme 102, die mit einem Wechselstromverbraucher oder Last (nicht dargestellt) verbunden ist. Die Anlage 10 umfasst einen Schalter 11 mit einer ersten und zweiten Schalterklemme 111, 112 und einem ersten und zweiten Thyristor 113, 114, einen Energiespeicher 12, einen Wechselrichter 13 mit einem Nennpotenzial, einen Stromsensor 14, einen ersten Spannungssensor 15 und eine Steuereinrichtung 16, die an den Schalter 11, den Wechselrichter 13 und die Sensoren 14, 15 gekoppelt ist.

Die erste Schalterklemme 111 ist an die erste Anschlussklemme 101 angeschlossen, die zweite Schalterklemme 112 ist an die zweite Anschlussklemme 102 angeschlossen. Der erste Thyristor 113 ist zwischen die Schalterklemmen 111, 112 geschaltet, der zweite Thyristor 114 ist antiparallel zu dem ersten Thyristor 113 zwischen die Schalterklemmen 111, 112 geschaltet.

Der Wechselrichter 13 ist mit seinem Wechselspannungsausgang an die zweite Anschlussklemme 102 und die zweite Schalterklemme 112 und mit seinem Gleichspannungseingang an den Energiespeicher 12 angeschlossen. Er ist somit zwischen die zweite Anschlussklemme 102 und den Energiespeicher 12 und ebenso zwischen die zweite Schalterklemme 112 und den Energiespeicher 12 geschaltet.

Der Stromsensor 14 ist beispielhaft an die zweite Schalterklemme 112 gekoppelt und kann somit den Strom erfassen, der durch den Schalter 11 fließt und auch als Schalterstrom bezeichnet wird. Er kann jedoch auch an die erste Schalterklemme 111 gekoppelt sein. Der Schalterstrom ist positiv, wenn er von der ersten zu der zweiten Schalterklemme 111, 112, also in Anlagenvorwärtsrichtung fließt.

Der erste Spannungssensor 15 ist an die erste Anschlussklemme 101 gekoppelt und kann somit das Potenzial erfassen, das an der ersten Anschlussklemme 101 anliegt und auch als erstes Potenzial als bezeichnet wird.

Bei dieser Ausführungsform sind die Thyristoren 113, 114 beispielhaft als normale Thyristoren und nicht als GTO-Thyristoren ausgebildet und derart geschaltet, dass die Vorwärtsrichtung des ersten Thyristors 113 von der ersten zu der zweiten Schalterklemme 111, 112 und somit von der ersten zu der zweiten Anschlussklemme 101, 102 weist, und die Vorwärtsrichtung des zweiten Thyristors 114 von der zweiten zu der ersten Schalterklemme 114, 113 und somit von der zweiten zu der ersten Anschlussklemme 102, 101 weist.

Bei dieser Ausführungsform ist die Steuereinrichtung 16 gemäß einer ersten Ausführungsform ausgebildet, und zwar derart, dass sie

- den Schalterstrom und das erste Potenzial auswerten kann;

- einen ersten Fehlerfall erkennen kann, in dem der Betrag des ersten Potenzials unzulässig sinkt und der Betrag des Schalterstroms unzulässig steigt, und sie in diesem Fall

  • den Wechselrichter 13 derart ansteuert, dass er ein zweites Potenzial erzeugt, das an der zweiten Schalterklemme 102 und somit auch an der zweiten Anschlussklemme 112 anliegt und den Schalterstrom auf Null treibt;
  • nach dem Einstellen des zweiten Potenzials den Schalterstrom überprüft, indem sie

    - den Betrag des Schalterstroms bis zu einem vorgegebenen ersten Prüfzeitpunkt, der nach dem Einstellen des zweiten Potenzials liegt, mit einem vorgegebenen Schwellenwert vergleicht und bei Überschreitung dieses Schwellenwertes ein erstes Prüfergebnis als positiv und andernfalls als negativ wertet;
    - bei positivem ersten Prüfergebnis das zweite Potenzial umkehrt;
    - bei negativem ersten Prüfergebnis den Schalterstrom zu einem vorgegebenem zweiten Prüfzeitpunkt, der bei oder nach dem ersten Prüfzeitpunkt liegt, mit Null vergleicht und bei Abweichung von Null ein zweites Prüfergebnis als positiv wertet und andernfalls als negativ;
    - bei positivem zweiten Prüfergebnis das zweite Potenzial umkehrt.

Der erste Fehlerfall bedeutet, dass die von der Wechselstromquelle gelieferte Versorgungsspannung zumindest kurzzeitig einbricht oder gar ausfällt, und kann beispielsweise auftreten, wenn am Schalter 11 der Schalterstrom dem ersten Potenzial nacheilt. Denn wenn beispielsweise der zweite Thyristor 114 den negativen, also in Rückwärtsrichtung fließenden Schalterstrom leitet und an der ersten Anschlussklemme 101 das erste Potenzial aufgrund der Phasenverschiebung bereits positiv ist und in dieser Situation die Versorgungsspannung einbricht, dann entsteht aufgrund des Regeleingriffs des Wechselrichters 13, der an der zweiten Anschlussklemme 102 das für die unterbrechungsfreie Stromversorgung erforderliche positive zweite Potenzial erzeugt, eine unerwünschte negative, also in Rückwärtsrichtung weisende Spannung über dem Schalter 11. Diese negative Spannung stellt für den zweiten Thyristor 114 eine Vorwärtsspannung dar und treibt den negativen Schalterstrom durch den zweiten Thyristor 114 in die Höhe, sodass dieser nicht durch Nullwerden des Schalterstroms erlöschen kann. Es besteht die Gefahr, dass der Wechselrichter 13 und/oder der zweite Thyristor 114 zerstört wird und dass die von dem Wechselrichter 13 für die unterbrechungsfreie Stromversorgung gelieferte Leistung nicht in ausreichendem Maße zu dem Wechselstromverbraucher gelangt, da ein zu großer Anteil von der Wechselstromquelle aufgenommen wird.

Hier greift nun die Steuereinrichtung 16 ein, indem sie den Wechselrichter 13 ansteuert, damit dieser von seinem normalen Regeleingriff für die unterbrechungsfreie Stromversorgung abweicht und an der zweite Anschlussklemme 102 ein Potenzial, also das zweite Potenzial, erzeugt, das diese negative Spannung und somit die Vorwärtsspannung des zweiten Thyristors 114 ausgleicht oder gar überkompensiert. Hierfür muss das zweite Potenzial ausreichend groß sein und dem negativen Schalterstrom entgegenwirken, was mit der oben stehenden Formel ausgedrückt werden kann. Da wie oben erwähnt das Vorgabepotenzial gleich dem Nennpotenzial des Wechselrichters 13 ist, wird also in dem geschilderten Beispiel der Wechselrichter 13 das zweite Potenzial auf einen Wert einstellen, der gleich dem negativen Nennpotenzial ist.

Folglich ist die Steuereinrichtung 16 derart ausgebildet, dass sie

• den Wechselrichter 13 derart ansteuert, dass er das zweite Potenzial derart erzeugt, dass

$$\mathrm{sgn(iS)} \cdot v1 < \mathrm{sgn(iS)} \cdot v2$$

oder $-v2/v1 > 1$

gilt, worin v1 der Momentanwert des ersten Potenzials ist, v2 der Momentanwert des zweiten Potenzials ist, und iS der Momentanwert des Schalterstroms ist.

Es kann jedoch vorkommen, dass das anzulegende zweite Potenzial fehlerhaft bestimmt oder ermittelt oder berechnet wird. Eine fehlerhafte Bestimmung liegt beispielsweise dann vor, wenn zum Zeitpunkt der Erfassung des Schalterstroms das Vorzeichen des Schalterstroms negativ ist, der Schalterstrom jedoch bis zum Erzeugen des zweiten Potenzials mittels des Wechselrichters 13 sein Vorzeichen wechselt. Dies kann beispielsweise bei einer schnellen Veränderung des Schalterstroms geschehen.

Ein weiterer Grund für eine fehlerhafte Ermittlung des zweiten Potenzials kann beispielsweise eine hohe Latenzzeit oder Ungenauigkeit bei der Erfassung oder Messung des Schalterstroms sein. Liegen beispielsweise zwei Messzeitpunkte, an denen der Schalterstrom erfasst wird, zu weit auseinander, dann ist eine Änderung des Vorzeichens des Schalterstroms möglich, ohne dass dieser Vorzeichenwechsel rechtzeitig durch die Steuereinrichtung 16 erfasst wird.

In diesem Fall tritt genau der gegenteilige Effekt des oben erwähnten Regeleingriffs zum Ausgleich der negativen Spannung auf. Denn aufgrund der Tatsache, dass das Vorzeichen des Schalterstrom bereits vor Erzeugen des zweiten Potenzials an der zweiten Schalterklemme 102 wechselt, fließt nun beispielsweise ein positiver Schalterstrom durch den ersten Thyristor 113. Wird nun das mittlerweile eingestellte zweite Potenzial zu einem Zeitpunkt t1 an der zweiten Schalterklemme 102 erzeugt, entsteht zwischen der ersten und der zweiten Schalterklemme 101, 102 eine positive Spannung, die für den ersten Thyristor 113 eine Vorwärtsspannung darstellt und den positiven Schalterstrom durch den ersten Thyristor 113 antreibt, sodass dieser nicht durch Nullwerden des Schalterstroms erlöschen kann. Es besteht wiederum die Gefahr, dass der Wechselrichter 13 und/oder der erste Thyristor 113 zerstört wird und die von dem Wechselrichter 13 für die unterbrechungsfreie Stromversorgung gelieferte Leistung nicht in ausreichendem Maße zu dem Wechselstromverbraucher gelangt.

Hier greift nun die Steuereinrichtung 16 ein zweites Mal ein, indem sie das zweite Potenzial umkehrt und somit ein korrektes Potenzial an der zweiten Schalterklemme 102 erzeugt, das zum Erlöschen des nun leitenden ersten Thyristors 113 und somit zu der Trennung des Wechselstromverbrauchers und des Wechselrichters 13 vom Versorgungsnetz führt. Auslöser für die zweite Steuerhandlung ist die Überwachung des Schalterstroms nach dem Erzeugen des zweiten Potenzials. Überschreitet der Betrag des Schalterstroms zu einem Zeitpunkt t2, der nach dem Erzeugen des zweiten Potenzials liegt, einen bestimmten Schwellenwert, der hier auch als zweiter Schwellenwert SW2 bezeichnet wird, oder ist dieser Betrag zu einem vorgegebenen Prüfzeitpunkt nach dem Erzeugen des zweiten Potenzials, nicht auf Null gesunken, dann wird das zuvor Potenzial umgekehrt. Dies führt dazu, dass im beschriebenen Fall nun zwischen der ersten und der zweiten Schalterklemme 101, 102 eine negative Spannung anliegt, die für den ersten Thyristor 113 eine Rückwärtsspannung darstellt und den Schalterstrom durch den ersten Thyristor 113 auf Null treibt, sodass dieser durch Nullwerden des Schalterstroms erlöscht.

Diese Anlage 10 führt somit eine bevorzugte Ausführungsform eines Verfahrens zum Steuern einer unterbrechungsfreien Stromversorgung aus, das die zuvor beschriebenen Schritte und Merkmale umfasst.

In FIG. 2 ist eine zweite Ausführungsform der Anlage 10 schematisch dargestellt. Diese Ausführungsform ähnelt der ersten Ausführungsform, sodass im Folgenden vor Allem die Unterschiede näher erläutert werden.

Bei dieser Ausführungsform umfasst die Anlage 10 beispielhaft einen zweiten Spannungssensor 17, eine Spule 18, einen Kondensator 19 und einen Transformator 20.

Der zweite Spannungssensor 17 ist an die Steuereinrichtung 16 und an die zweite Anschlussklemme 102 gekoppelt und kann somit das zweite Potenzial erfassen, das an der zweiten Anschlussklemme 102 anliegt. Die Steuereinrichtung 16 regelt mithilfe des zweiten Spannungssensors 17 den Wechselrichter 13.

Die Spule 18 ist zwischen die erste Anschlussklemme 101 und die erste Schalterklemme 112 geschaltet. Ihre Reaktanz und Induktivität sind beispielhaft so gewählt, dass sie der Reaktanz und Induktivität der Wechselstromquelle entsprechen. Falls die Wechselstromquelle beispielsweise ein Wechselstromnetz ist, so ist ihre Reaktanz typischerweise im Wesentlichen eine Induktanz, die von ihrer Induktivität abhängt, die wiederum mit der Länge der Leitungen des Wechselstromnetzes zunimmt. Der Kondensator 19 ist zwischen die erste Schalterklemme 112 und Masse geschaltet. Es ist beispielhaft aber auch möglich, dass die Spule 18 entfällt oder auf der anderen Seite des Schalters 11 angeordnet ist und/oder der Kondensator 19 entfällt oder auf der anderen Seite des Schalters 11 angeordnet ist.

Der Transformator 20 ist zwischen den Wechselrichter 13 und die zweite Schalterklemme 112 geschaltet und somit auch zwischen den Wechselrichter 13 und die zweite Anschlussklemme 102. Er dient dazu, die von dem Wechselrichter 13 gelieferte Wechselspannung zu vergrößern.

Der Wechselrichter 13 ist beispielhaft bidirektional ausgebildet, kann also nicht nur die von der Energiespeicher 12 gelieferte Gleichspannung in eine Wechselspannung an der zweiten Schalterklemme 112 und der zweiten Anschlussklemme 102 umwandeln, sondern auch eine an der zweiten Schalterklemme 112 und der zweiten Anschlussklemme 102 anliegende Wechselspannung in eine Gleichspannung zum Aufladen des Energiespeichers 12 umwandeln. Folglich bildet sein Wechselspannungsausgang auch einen Wechselspannungseingang und sein Gleichspannungseingang auch einen Gleichspannungsausgang. Es ist beispielhaft aber auch möglich, dass der Wechselrichter 13 nicht bidirektional ist und stattdessen ein Gleichrichter (nicht dargestellt) parallel zu dem Wechselrichter 13 geschaltet und an die Steuereinrichtung 16 gekoppelt ist.

Bei dieser Ausführungsform ist die Steuereinrichtung 16 gemäß einer zweiten Ausführungsform ausgebildet, die der ersten Ausführungsform ähnelt, sodass im Folgenden vor Allem die Unterschiede näher erläutert werden.

Bei dieser Ausführungsform ist die Steuereinrichtung 16 derart ausgebildet, dass sie

-    einen zweiten Fehlerfall erkennen kann, in dem der Betrag des ersten Potenzials unzulässig sinkt und der Betrag des Schalterstroms sinkt, und einen Schwankungsfall erkennen kann, in dem der Betrag des ersten Potenzials zulässig steigt oder zulässig sinkt, und in jedem dieser Fälle den Wechselrichter 13 derart ansteuert, dass er

     •    das zweite Potenzial so, wie es für eine unterbrechungsfreie Stromversorgung erforderlich ist, einstellt und an der zweiten Anschlussklemme 102 erzeugt;

-    in dem ersten und zweiten Fehlerfall den Thyristoren 113, 114 keinen Zündstrom zuführt.

Dieser zweite Fehlerfall bedeutet wie der erste Fehlerfall, dass die von der Wechselstromquelle gelieferte Versorgungsspannung zumindest kurzzeitig einbricht oder gar ausfällt, und kann beispielsweise auftreten, wenn am Schalter 11 der Strom dem ersten Potenzial vorauseilt oder mit dieser in Phase ist. Denn wenn beispielsweise der erste Thyristor 113 den positiven, also in seiner Vorwärtsrichtung fließenden Schalterstrom leitet und an der ersten Anschlussklemme 101 das erste Potenzial aufgrund der Phasenverschiebung schon positiv ist und in dieser Situation die Versorgungsspannung einbricht, dann entsteht aufgrund des Regeleingriffs des Wechselrichters 13, der an der zweiten Anschlussklemme 102 das für die unterbrechungsfreie Stromversorgung erforderliche positive zweite Potenzial erzeugt, eine erwünschte negative, also in Anlagenrückwärtsrichtung weisende Spannung über dem Schalter 11. Diese negative Spannung treibt den positiven Schalterstrom durch den ersten Thyristor 113 auf Null, sodass dieser durch Nullwerden des Schalterstroms erlöscht. Es besteht daher nicht die Gefahr, dass der Wechselrichter 13 und/oder der erste Thyristor 113 zerstört wird und dass die von dem Wechselrichter 13 für die unterbrechungsfreie Stromversorgung gelieferte Leistung nicht in ausreichendem Maße zu dem Wechselstromverbraucher gelangt. Hier muss nun die Steuereinrichtung 16 nicht eingreifen, sondern kann der Wechselrichter 13 für die unterbrechungsfreie Stromversorgung sorgen.

Bei dieser Ausführungsform ist die Steuereinrichtung 16 derart ausgebildet, dass sie

-    überwachen kann, ob nach dem Umkehren der Betrag des Schalterstroms auf Null gesunken ist oder der Schalterstrom Null erreicht hat;
-    sobald der Betrag des Schalterstroms auf Null gesunken ist oder der Schalterstrom Null erreicht hat, eine Wartezeit abwartet, für die

$$TW = A4 \cdot tq$$

     mit $A4 \geq 1$ gilt, worin TW die Wartezeit ist, A4 ein vierter Anteilsfaktor ist, und tq die Freiwerdezeit der Thyristoren 113, 114 ist;
-    nach Ablauf der Wartezeit den Wechselrichter 13 derart ansteuert, dass er das zweite Potenzial so, wie es für eine unterbrechungsfreie Stromversorgung erforderlich ist, einstellt.

Bei dieser Ausführungsform ist die Steuereinrichtung 16 derart ausgebildet, dass sie

-    das Vorgabepotenzial derart wählt, dass

$$v0 = A3 \cdot VWR$$

mit A3 ≤ 1

gilt, worin A3 ein dritter Anteilsfaktor ist, der hier beispielhaft gleich 0,5 ist, und VWR das Nennpotenzial des Wechselrichters 13 ist.

Alternativ oder zusätzlich kann die Steuereinrichtung 16 derart ausgebildet sein, dass sie

- das Vorgabepotenzial zumindest zeitweise derart wählt, dass

$$v0 = v(iS) = L \cdot d|iS|/dt$$

gilt, worin L die Induktivität der Wechselstromquelle und des Abschnitts der Anlage 10 zwischen der ersten Anschlussklemme 101 und der zweiten Schalterklemme 112 ist, und d|iS|/dt die zeitliche Ableitung des Betrags des Schalterstroms ist.

L ist somit bei dieser Ausführungsform im Wesentlichen die Summe aus der Induktivität der Wechselstromquelle und der Induktivität der Spule 18.

Alternativ oder zusätzlich kann die Steuereinrichtung 16 derart ausgebildet sein, dass sie

- das Vorgabepotenzial zumindest zeitweise durch eine durch den Schalterstrom geführte Regelung ermittelt und insbesondere das Vorgabepotenzial in dem Maße verringert, in dem der Betrag des Schalterstroms sinkt.

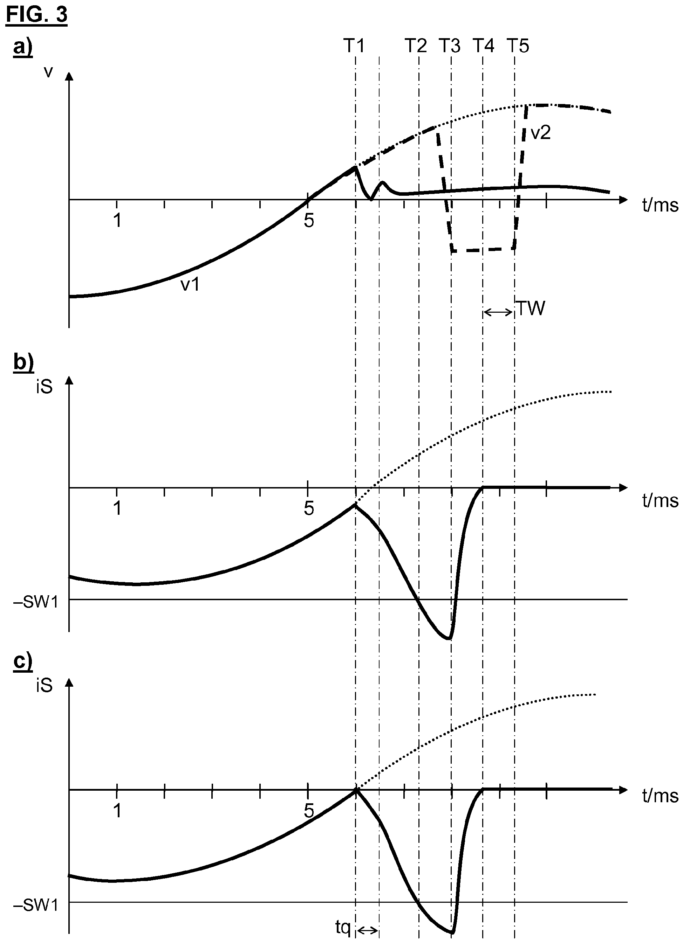

In FIG. 3a ist der zeitliche Verlauf des ersten und zweiten Potenzials in der Anlage der FIG. 2 darstellt, wenn der erste Fehlerfall auftritt. Das erste Potenzial ist mit einer durchgezogenen Linie und das zweite Potenzial mit einer gestrichelten Linie dargestellt. Die Netzfrequenz beträgt beispielhaft 50 Hz. In FIG. 3b ist der mit FIG. 3a synchronisierte zeitliche Verlauf des Schalterstroms dargestellt, der dem ersten Potenzial beispielhaft um 1,3 ms nacheilt. Die gepunktete Linie zeigt jeweils den Sollverlauf der Potenziale beziehungsweise des Schalterstroms.

Zu einem Zeitpunkt T1 tritt im Wechselstromnetz ein Fehler auf, der einen Zusammenbruch des ersten Potenzials beispielhaft 1 ms nach einem positiven Nulldurchgang bewirkt. Zu diesem Zeitpunkt T1 ist der Schalterstrom noch negativ, der zweite Thyristor 114 leitet und der erste Thyristor 113 sperrt. Der Wechselrichter 13 stellt zunächst gemäß seinem normalen Regeleingriff, der für die unterbrechungsfreie Stromversorgung erforderlich ist, das zweite Potenzial auf die positiven Werte der gepunkteten Sollkurve ein. Hierdurch liegt nun über dem leitenden zweiten Thyristor 114 eine Vorwärtsspannung an, die den Schalterstrom in Anlagenrückwärtsrichtung antreibt.

Zu einem Zeitpunkt T2 erkennt die Steuereinrichtung 16, dass der Betrag des ersten Potenzials unzulässig gesunken ist, da er einen vorgegebenen Schwellenwert unterschritten hat, und dass der Betrag des Schalterstroms unzulässig gestiegen ist, da er einen vorgegebenen ersten Schwellenwert SW1 überschritten hat. Sie führt daher einerseits den Thyristoren 113, 114 keinen Zündstrom zu. Andererseits steuert sie den Wechselrichter 13 derart an, dass er das zweite Potenzial auf v2 = -0,5 · VWR einstellt. Die Erzeugung des zweiten Potentials erfolgt aufgrund der Reaktionszeit, die die Steuereinrichtung 16 und der Wechselrichters 13 für das Berechnen und Einstellen benötigen, zu einem Zeitpunkt T3. Hierdurch wird die Spannung über dem Schalter 11 umgepolt und weist nun in Anlagenvorwärtsrichtung, sodass sie den Schalterstrom auf Null treibt und sein Betrag zu sinken beginnt. Die Steuereinrichtung 16 überwacht nun, ob dieser Betrag auf Null gesunken ist oder der Schalterstrom Null erreicht hat.

Zu einem Zeitpunkt T4 erkennt die Steuereinrichtung 16, dass der Betrag des Schalterstroms auf Null gesunken ist oder der Schalterstrom Null erreicht hat. Sie wartet daher die Wartezeit ab, sodass der soeben erloschene zweite Thyristor 114 sich regenerieren und seine volle Sperrfähigkeit erreichen kann. Die Freiwerdezeit der Thyristoren 113, 114 beträgt hier beispielhaft tq = 330 μs, und für die Wartezeit ist hier beispielhaft TW = 670 μs gewählt.

Zu einem Zeitpunkt T5 ist die Wartezeit abgelaufen, beide nicht angesteuerten Thyristoren 113, 114 sperren sicher und verhindern einen unerwünschten Leistungsfluss zurück in das Wechselstromnetz. Die Steuereinrichtung 16 steuert daher den Wechselrichter 13 derart an, dass er das zweite Potenzial so, wie es für eine unterbrechungsfreie Stromversorgung erforderlich ist, einstellt, also auf den Sollverlauf.

Der Abstand zwischen den Zeitpunkten T1 und T2 beträgt hier beispielhaft 1,33 ms, kann aber auch deutlich geringer ausfallen und beispielsweise unter 0,3 ms liegen.

Der Abstand zwischen den Zeitpunkten T3 und T4 beträgt hier beispielhaft 0,67 ms, kann aber auch deutlich geringer ausfallen und beispielsweise unter 0,3 ms liegen; dies kann beispielsweise durch Vergrößern des Vorgabepotenzials und/oder dadurch erreicht werden, dass die Spannung über dem Schalter 11 früher, also bei einem niedrigeren Betrag des Schalterstroms umgepolt wird.

FIG. 3c ähnelt FIG. 3b, jedoch eilt der Schalterstrom dem ersten Potenzial weniger nach, nämlich beispielhaft um 1 ms. Zum Zeitpunkt T1 ist daher der Schalterstrom nicht mehr negativ, sondern befindet sich in seinem positiven Nulldurchgang. Somit erlischt zwar der bisher leitende zweite Thyristor 114, zündet aber erneut, da innerhalb seiner Freiwerdezeit über ihm eine Vorwärtsspannung anliegt, die den Schalterstrom in Anlagenrückwärtsrichtung, also in seiner Vorwärtsrichtung antreibt.

Dies geschieht ebenso, falls der Schalterstrom dem ersten Potenzial noch weniger oder gar nicht nacheilen oder gar vorauseilen sollte und nach seinem positiven Nulldurchgang innerhalb der Freiwerdezeit über dem zweiten Thyristor 114 eine Vorwärtsspannung anliegen sollte.

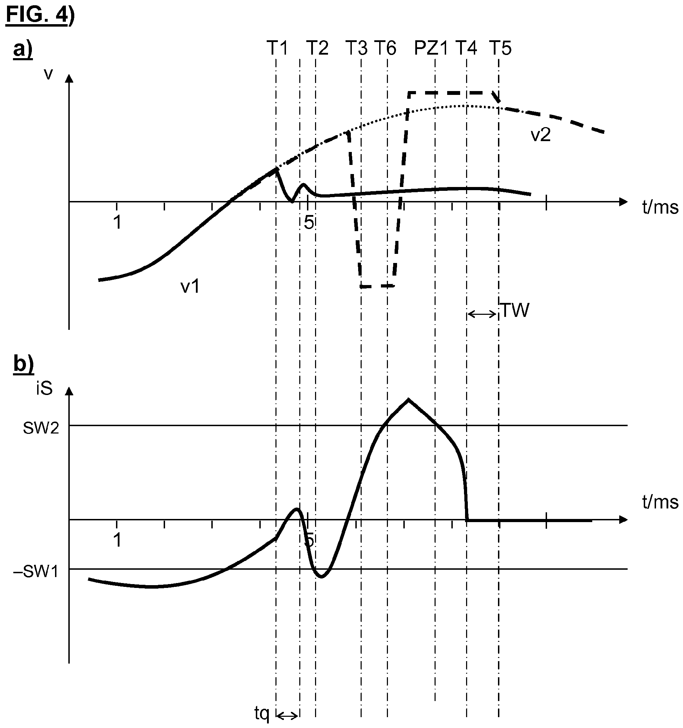

FIG. 4 zeigt die Auswirkungen einer fehlerhaften Ermittlung des anzulegenden zweiten Potenzials. In FIG. 4a ist der zeitliche Verlauf des ersten und zweiten Potenzials in der Anlage der FIG. 2 dargestellt. In FIG. 4b ist der mit FIG. 4a synchronisierte, zeitliche Verlauf des Schalterstroms dargestellt.

Der in FIG. 4 dargestellte Fall ähnelt demjenigen der FIG. 3, sodass im Folgenden vor Allem die Unterschiede näher erläutert werden. In FIG. 4b ist dargestellt, dass aufgrund von Ausgleichs- und Überschwingeffekten zwischen den Zeitpunkten T1 und T2 der noch negative Schalterstrom kurzzeitig sein Vorzeichen wechselt und so der zum Zeitpunkt T1 noch sperrende, aber bereits angesteuerte erste Thyristor 113 zündet und kurzzeitig leitend wird. Danach, aber noch vor dem Zeitpunkt T2 wechselt der Schalterstrom abermals sein Vorzeichen und wird wieder negativ. Außerdem wechselt der Schalterstrom in diesem Fall zwischen dem Zeitpunkt T2, an dem der erste Fehlerfall erkannt wird, und dem Zeitpunkt T3, an dem mittels des Wechselrichters 13 das zweite Potenzial auf den gewünschten Wert eingestellt und an die zweite Anschlussklemme 102 angelegt ist, wiederum sein Vorzeichen und ist positiv. Dies führt dazu, dass zwar wegen des angelegten negativen zweiten Potenzials und des nahe bei Null liegenden ersten Potenzials eine positive, also in Anlagenvorwärtsrichtung weisende Spannung über dem Schalter 11 anliegt, diese jedoch den Schalterstrom nicht, wie dem in FIG. 3 beschriebenen Fall, auf Null treibt, sondern im Gegenteil den Schalterstrom, der ja in diesem Fall nun positiv ist, antreibt, wodurch er weiter ansteigt.

Zu einem Zeitpunkt T6, der vor oder bei einem ersten vorgegebenen Prüfzeitpunkt PZ1 liegt, erkennt die Steuereinrichtung 16, dass der Betrag des Schalterstroms einen vorgegebenen zweiten Schwellenwert SW2 überschritten hat, und greift abermals ein. Dieser Eingriff erfolgt dergestalt, dass das angelegte zweite Potenzial umgekehrt und somit auf v2 = +0.5 · VWR eingestellt wird. Hierdurch wird die Spannung über dem Schalter 11 umgepolt und weist nun in Anlagenrückwärtsrichtung, sodass sie den Schalterstrom auf Null treibt und sein Betrag zu sinken beginnt. Die Steuereinrichtung 16 überwacht nun, ob dieser Betrag auf Null gesunken ist oder der Schalterstrom Null erreicht hat.

Die Steuereinrichtung 16 ist Bei dieser Ausführungsform derart ausgebildet, dass

- nach dem Umkehren

$$v2 = sgn(iS) \cdot v0$$

mit v0 > 0
gilt, wobei v0 = A3 · VWR = 0,5 · VWR gilt.

Zum Zeitpunkt T4 erkennt die Steuereinrichtung 16, dass der Betrag des Schalterstroms auf Null gesunken ist oder der Schalterstrom Null erreicht hat. Sie wartet die Wartezeit ab, damit sich der erste Thyristor 113 regenerieren und seine volle Sperrfähigkeit erreichen kann.

Zum Zeitpunkt T5 ist die Wartezeit abgelaufen, beide Thyristoren 113, 114 sperren sicher und verhindern einen unerwünschten Leistungsfluss zurück in das Wechselstromnetz. Die Steuereinrichtung 16 steuert daher den Wechselrichter 13 derart an, dass er das zweite Potenzial so, wie es für eine unterbrechungsfreie Stromversorgung erforderlich ist, einstellt, also auf den Sollverlauf.

Der Abstand zwischen den Zeitpunkten T6 und T4 beträgt hier beispielhaft 1,5 ms, kann aber auch deutlich geringer oder höher ausfallen und beispielsweise unter 0,3 ms liegen; dies kann beispielsweise durch Vergrößern des Vorgabepotenzials und/oder Verkleinern der Induktivität der Spule 18 und/oder durch Vergrößern der Kapazität des Kondensators 19 erreicht werden.

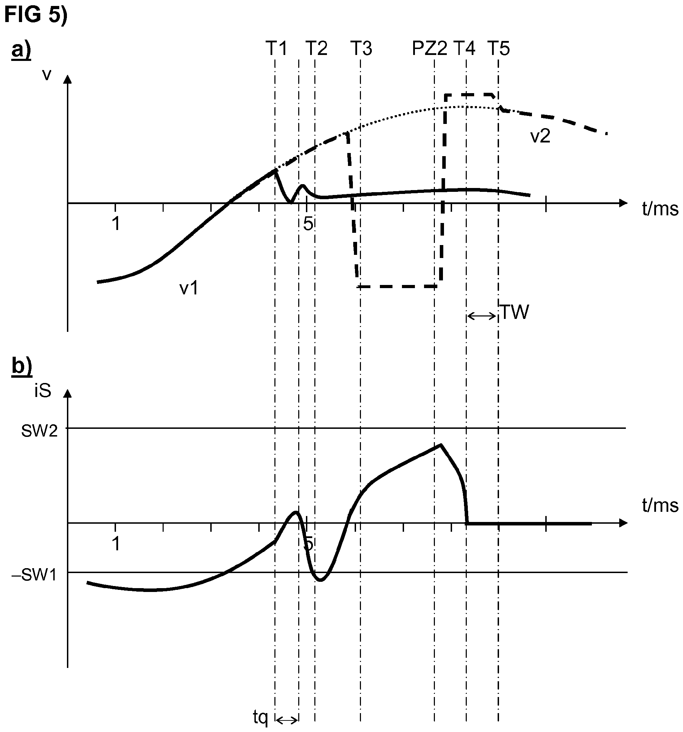

FIG. 5 zeigt die Auswirkungen einer fehlerhaften Ermittlung des anzulegenden zweiten Potenzials bei einem anderen Verhalten des Schalterstroms. In FIG. 5a ist der zeitliche Verlauf des ersten und zweiten Potenzials in der Anlage der FIG. 2 dargestellt. In FIG. 5b ist der mit FIG. 5a synchronisierte, zeitliche Verlauf des Schalterstroms dargestellt.

Der in FIG. 5 dargestellte Fall ähnelt demjenigen der FIG. 4, sodass im Folgenden vor Allem die Unterschiede näher erläutert werden. Im Gegensatz zu FIG. 4b überschreitet in diesem Fall der Betrag des Schalterstroms nach dem zum Zeitpunkt T3 erfolgten Erzeugen des zweiten Potenzials nicht den zweiten Schwellenwert SW2. Um ein fehlerhaftes Einstellen des zweiten Potenzials trotzdem sicher erkennen zu können, überprüft die Steuereinrichtung 16 zum vorgegebenen zweiten Prüfzeitpunkt PZ2, der bei dieser Ausführungsform bei dem ersten Prüfzeitpunkt PZ1 liegt oder gleich dem ersten Prüfzeitpunkt PZ1 ist, ob gemäß den Erwartungen der Betrag des Schalterstroms auf Null gefallen ist oder der Schalterstrom Null erreicht hat. Ist dies nicht der Fall, dann greift die Steuereinrichtung 16 abermals ein und kehrt das zweite Potenzial analog zum Vorgehen gemäß FIG. 4 um auf v2 = +0.5 · VWR. Hierdurch wird die Spannung über dem Schalter 11 wiederum umgepolt, sodass sie den Schalterstrom auf Null treibt und sein Betrag zu sinken beginnt. Die Steuereinrichtung 16 überwacht nun wieder, ob dieser Betrag auf Null gesunken ist oder der Schalterstrom Null erreicht hat.

Zum Zeitpunkt T5 erkennt die Steuereinrichtung 16, dass der Betrag des Schalterstroms auf Null gesunken ist oder der Schalterstrom Null erreicht hat. Sie wartet daher dann noch die Wartezeit ab, sodass sich der erste Thyristor 113 regenerieren und seine volle Sperrfähigkeit erreichen kann.

Zum Zeitpunkt T6 ist die Wartezeit abgelaufen, beide Thyristoren 113, 114 sperren sicher und verhindern einen unerwünschten Leistungsfluss zurück in das Wechselstromnetz. Die Steuereinrichtung 16 steuert daher den Wechselrichter 13 derart an, dass er das zweite Potenzial so, wie es für eine unterbrechungsfreie Stromversorgung erforderlich ist, einstellt, also auf den Sollverlauf.

Der Abstand zwischen den Zeitpunkten PZ2 und T4 beträgt hier beispielhaft 0,67 ms, kann aber auch deutlich geringer oder höher ausfallen und beispielsweise unter 0,3 ms liegen; dies kann beispielsweise durch Vergrößern des Vorgabepotenzials oder Verkleinern der Induktivität der Spule 18 und/oder durch Vergrößern der Kapazität des Kondensators 19 erreicht werden.

BEZUGSZEICHEN

| 10 | Anlage für eine unterbrechungsfreie Stromversorgung |
| 101/102 | erste/zweite Anschlussklemme von 10 |
| 11 | Schalter |
| 111/112 | erste/zweite Schalterklemme von 11 |
| 113/114 | erster/zweiter Thyristor von 11 |
| 12 | Energiespeicher |
| 13 | Wechselrichter |
| 14 | Stromsensor |
| 15 | erster Spannungssensor |
| 16 | Steuereinrichtung |
| 17 | zweiter Spannungssensor |
| 18 | Spule |
| 19 | Kondensator |
| 20 | Transformator |
| A1/A2/A3/A4 | erster/zweiter/dritter/vierter Anteilsfaktor |
| iS | Strom durch 11, Schalterstrom |
| PZ1 | erster Prüfzeitpunkt, bis zu dem 16 iS mit SW2 vergleicht |
| PZ2 | zweiter Prüfzeitpunkt, zu dem 16 iS mit Null vergleicht |
| SW1/SW2 | erster/zweiter Schwellenwert |
| tq | Freiwerdezeit von 113, 114 |
| TW | Wartezeit |
| T1 | Zeitpunkt, zu dem im Wechselstromnetz ein Fehler auftritt |
| T2 | Zeitpunkt, zu dem 16 erkennt, dass |v1| unzulässig gesunken ist und |iS| SW1 überschritten hat |
| T3 | Zeitpunkt, zu dem 13 v2 eingestellt hat |
| T4 | Zeitpunkt, zu dem 16 erkennt, dass |iS| auf Null gesunken ist |
| T5 | Zeitpunkt, zu dem TW abgelaufen ist und 13 v2 so einstellt, wie es für eine unterbrechungsfreie Stromversorgung erforderlich ist |
| T6 | Zeitpunkt, zu dem 16 erkennt, dass |iS| SW2 überschritten hat |
| v0 | Vorgabepotenzial |
| v1 | Potenzial an 101/111, erstes Potenzial |
| v2 | Potenzial an 102/112, zweites Potenzial |
| VWR | Nennpotenzial von 13 |

**Patentansprüche**

1. Verfahren zum Steuern einer unterbrechungsfreien Stromversorgung mithilfe einer Anlage (10) für eine unterbrechungsfreie Stromversorgung, wobei die Anlage (10) umfasst

    - eine erste Anschlussklemme (101), die mit einer Wechselstromquelle verbunden werden kann;
    - eine zweite Anschlussklemme (102), die mit einem Wechselstromverbraucher verbunden werden kann;
    - einen Schalter (11), umfassend

        • eine erste Schalterklemme (111), die mit der ersten Anschlussklemme (101) verbunden ist;
        • eine zweite Schalterklemme (112), die mit der zweiten Anschlussklemme (102) verbunden ist;
        • einen ersten Thyristor (113), der zwischen die Schalterklemmen (111, 112) geschaltet ist;
        • einen zweiten Thyristor (114), der antiparallel zu dem ersten Thyristor (113) zwischen die Schalterklemmen (111, 112) geschaltet ist;

    - einen Energiespeicher (12);
    - einen Wechselrichter (13), der mit der zweiten Anschlussklemme (102) und dem Energiespeicher (12) verbunden ist;
    wobei
    - ein Schalterstrom erfasst wird, der durch den Schalter (11) fließt;
    - ein erstes Potenzial erfasst wird, das an der ersten Anschlussklemme (101) anliegt;
    - in einem ersten Fehlerfall, in dem der Betrag des ersten Potenzials sinkt, so dass der Momentanwert des ersten Potentials eine erste vorgegebene Zulässigkeitsregel verletzt und der Betrag des Schalterstroms steigt, so dass der Momentanwert des Schalterstroms eine zweite vorgegebene Zulässigkeitsregel verletzt,

• mithilfe des Wechselrichters (13) ein zweites Potenzial, das an der zweiten Schalterklemme (102) anliegt, so eingestellt wird, dass der Schalterstrom auf Null getrieben wird;
• nach dem Einstellen des zweiten Potenzials der Schalterstrom überprüft wird, indem

- der Betrag des Schalterstroms bis zu einem vorgegebenen ersten Prüfzeitpunkt, der nach dem Einstellen des zweiten Potenzials liegt, erfasst und mit einem vorgegebenen Schwellenwert (SW2) verglichen wird und bei Überschreitung dieses Schwellenwertes (SW2) ein erstes Prüfergebnis als positiv und andernfalls als negativ gewertet wird;
- bei positivem ersten Prüfergebnis das zweite Potenzial umgekehrt wird;
- bei negativem ersten Prüfergebnis der Schalterstrom zu einem vorgegebenen zweiten Prüfzeitpunkt, der bei oder nach dem ersten Prüfzeitpunkt liegt, erfasst und mit Null verglichen wird und bei Abweichung von Null ein zweites Prüfergebnis als positiv und andernfalls als negativ gewertet wird;
- bei positivem zweiten Prüfergebnis das zweite Potenzial umgekehrt wird.

2. Verfahren nach Anspruch 1, wobei

- in dem ersten Fehlerfall

• das Einstellen des zweiten Potenzials derart erfolgt, dass
$\text{sgn}(iS) \cdot v1 \leq \text{sgn}(iS) \cdot v2$ oder $\text{sgn}(iS) \cdot v1 < \text{sgn}(iS) \cdot v2$
oder $-v2/v1 \geq 1$ oder $-v2/v1 > 1$

gilt, worin v1 der Momentanwert des ersten Potenzials ist, v2 der Momentanwert des zweiten Potenzials ist, und iS der Momentanwert des Schalterstroms ist.

3. Verfahren nach Anspruch 1 oder nach einem der vorigen Ansprüche, wobei

- das Umkehren gemäß folgender Formel erfolgt

$$v2(t2) = -A1 \cdot v2(t1)$$

mit $A1 \geq 1$ und $t2 > t1$
worin v2 der Momentanwert des zweiten Potenzials ist, t2 ein Zeitpunkt ist, der nach dem Umkehren liegt, t1 ein Zeitpunkt ist, der vor dem Umkehren liegt, und A1 ein erster Anteilsfaktor ist.

4. Verfahren nach Anspruch 1 oder nach einem der vorigen Ansprüche, wobei

- für den vorgegebenen zweiten Prüfzeitpunkt

$$PZ2 = T3 + A2 \cdot tq$$

mit $A2 \geq 1$
gilt, worin PZ2 der zweite Prüfzeitpunkt ist, T3 der Zeitpunkt ist, zu dem das zweite Potenzial eingestellt worden ist, A2 ein zweiter Anteilsfaktor ist, und tq die Freiwerdezeit der Thyristoren (113, 114) ist.

5. Verfahren nach Anspruch 1 oder nach einem der vorigen Ansprüche, wobei

- nach dem Umkehren

$$v2 = \text{sgn}(iS) \cdot v0$$

mit $v0 > 0$
gilt, worin v0 ein vorgegebenes Vorgabepotenzial ist, v2 der Momentanwert des zweiten Potenzials ist, und iS der Momentanwert des Schalterstroms ist.

6. Verfahren nach dem vorigen Anspruch, wobei

- das Vorgabepotenzial zumindest zeitweise derart gewählt wird, dass

$$v0 = A3 \cdot VWR$$

mit $0 < A3 \leq 1$
gilt, worin A3 ein dritter Anteilsfaktor ist, und VWR das Nennpotenzial des Wechselrichters (13) ist.

7. Verfahren nach einem der 2 vorigen Ansprüche, wobei

- das Vorgabepotenzial zumindest zeitweise derart gewählt wird, dass

$$v0 = v(iS)$$

gilt, worin v(iS) eine von dem Schalterstrom abhängige Funktion ist.

8. Verfahren nach dem vorigen Anspruch, wobei

- die Funktion derart gewählt wird, dass

$$v(iS) = L \cdot d|iS|/dt$$

gilt, worin L die Induktivität der Wechselstromquelle und des Abschnitts der Anlage (10) zwischen der ersten Anschlussklemme (101) und der zweiten Schalterklemme (112) ist, und d|iS|/dt die zeitliche Ableitung des Betrags des Schalterstroms ist.

9. Verfahren nach einem der 4 vorigen Ansprüche, wobei

- das Vorgabepotenzial zumindest zeitweise durch eine durch den Schalterstrom geführte Regelung ermittelt wird.

10. Verfahren nach Anspruch 1 oder nach einem der vorigen Ansprüche, wobei

- überwacht wird, ob der Betrag des Schalterstroms nach dem Umkehren auf Null gesunken ist;
- sobald der Betrag des Schalterstroms auf Null gesunken ist, eine Wartezeit abgewartet wird, für die

$$TW = A4 \cdot tq$$

mit $A4 \geq 1$

gilt, worin TW die Wartezeit ist, A4 ein vierter Anteilsfaktor ist, und tq die Freiwerdezeit der Thyristoren (113, 114) ist;
- nach Ablauf der Wartezeit mithilfe des Wechselrichters (13) das zweite Potenzial so, wie es für eine unterbrechungsfreie Stromversorgung erforderlich ist, eingestellt wird und/oder mithilfe des Wechselrichters eine Wirkleistung, die für eine unterbrechungsfreie Stromversorgung erforderlich ist, und/oder eine Blindleistung, die für eine unterbrechungsfreie Stromversorgung erforderlich ist, erzeugt wird.

11. Verfahren nach Anspruch 1 oder nach einem der vorigen Ansprüche, wobei

- in einem zweiten Fehlerfall, in dem der Betrag des ersten Potenzials sinkt und die erste vorgegebene Zulässigkeitsregel verletzt und der Betrag des Schalterstroms sinkt, und/oder

in einem Schwankungsfall, in dem der Betrag des ersten Potenzials steigt, so dass der Momentanwert des ersten Potenzials eine vorgegebene dritte Zulässigkeitsregel nicht verletzt, oder sinkt, so dass der Momentanwert des ersten Potenzials die vorgegebene erste Zulässigkeitsregel nicht verletzt,
mithilfe des Wechselrichters (13)

• das zweite Potenzial so, wie es für eine unterbrechungsfreie Stromversorgung erforderlich ist, eingestellt wird; und/oder
• eine Wirkleistung, die für eine unterbrechungsfreie Stromversorgung erforderlich ist, und/oder eine Blindleistung, die für eine unterbrechungsfreie Stromversorgung erforderlich ist, erzeugt wird.

12. Verfahren nach Anspruch 1 oder nach einem der vorigen Ansprüche, wobei

- das zweite Potenzial erfasst wird;
- der Wechselrichter (13) mithilfe des zweite Potenzials und/oder in Abhängigkeit von dem zweiten Potenzial gesteuert wird.

13. Anlage (10) für eine unterbrechungsfreie Stromversorgung, umfassend

- eine erste Anschlussklemme (101), die mit einer Wechselstromquelle verbunden werden kann;
- eine zweite Anschlussklemme (102), die mit einem Wechselstromverbraucher verbunden werden kann;
- einen Schalter (11), umfassend

• eine erste Schalterklemme (111), die mit der ersten Anschlussklemme (101) verbunden ist;
• eine zweite Schalterklemme (112), die mit der zweiten Anschlussklemme (102) verbunden ist;
• einen ersten Thyristor (113), der zwischen die Schalterklemmen (111, 112) geschaltet ist;
• einen zweiten Thyristor (114), der antiparallel zu dem ersten Thyristor (113) zwischen die Schalterklemmen (111, 112) geschaltet ist;

- einen Energiespeicher (12);
- einen Wechselrichter (13), der mit der zweiten Anschlussklemme (102) und dem Energiespeicher (12) verbunden ist;
- einen Stromsensor (14), der einen Schalterstrom erfassen kann, der durch den Schalter (11) fließt;

- einen ersten Spannungssensor (15), der ein erstes Potenzial erfassen kann, das an der ersten Anschlussklemme (102) anliegt;
- eine Steuereinrichtung (16), die an den Schalter (11), den Wechselrichter (13) und die Sensoren (14, 15) gekoppelt ist;

wobei die Steuereinrichtung (16) derart ausgebildet ist, dass sie

- den Schalterstrom und das erste Potenzial auswerten kann;
- einen ersten Fehlerfall erkennen kann, in dem der Betrag des ersten Potenzials sinkt, so dass der Momentanwert des ersten Potentials eine erste vorgegebene Zulässigkeitsregel verletzt und der Betrag des Schalterstroms steigt, so dass der Momentanwert des Schalterstroms eine zweite vorgegebene Zulässigkeitsregel verletzt, und sie in diesem Fall

    • den Wechselrichters (13) derart ansteuert, dass er ein zweites Potenzial erzeugt, das an der zweiten Schalterklemme (102) anliegt und den Schalterstrom auf Null treibt;
    • nach dem Einstellen des zweiten Potenzials den Schalterstrom überprüft, indem sie

        - den Betrag des Schalterstroms bis zu einem vorgegebenen ersten Prüfzeitpunkt, der nach dem Einstellen des zweiten Potenzials liegt, mit einem vorgegebenen Schwellenwert (SW2) vergleicht und bei Überschreitung dieses Schwellenwertes (SW2) ein erstes Prüfergebnis als positiv und andernfalls als negativ wertet;
        - bei positivem ersten Prüfergebnis das zweite Potenzial umkehrt;
        - bei negativem ersten Prüfergebnis den Schalterstrom zu einem vorgegebenen zweiten Prüfzeitpunkt, der bei oder nach dem ersten Prüfzeitpunkt liegt, mit Null vergleicht und bei Abweichung von Null ein zweites Prüfergebnis als positiv und andernfalls als negativ wertet;
        - bei positivem zweiten Prüfergebnis das zweite Potenzial umkehrt.

**14.** Anlage (10) nach Anspruch 13, wobei

- die Steuereinrichtung (16) derart ausgebildet ist, dass sie in dem ersten Fehlerfall

    • den Wechselrichters (13) derart ansteuert, dass für das zweite Potenzial
$\text{sgn(iS)} \cdot v1 \leq \text{sgn(iS)} \cdot v2$ oder $\text{sgn(iS)} \cdot v1 < \text{sgn(iS)} \cdot v2$

oder $-v2/v1 \geq 1$ oder $-v2/v1 > 1$

gilt, worin v1 der Momentanwert des ersten Potenzials ist, v2 der Momentanwert des zweiten Potenzials ist, und iS der Momentanwert des Schalterstroms ist.

**15.** Anlage (10) nach Anspruch 13 oder nach einem der vorigen Ansprüche, umfassend

- eine Spule (18), die zwischen die erste Anschlussklemme (101) und die erste Schalterklemme (111) oder zwischen die zweite Schalterklemme (102) und die zweite Anschlussklemme (112) geschaltet ist; und/oder
- einen Kondensator (19), der zwischen die erste Anschlussklemme (101) und Masse oder zwischen die erste Schalterklemme (111) und Masse oder zwischen die zweite Schalterklemme (112) und Masse oder zwischen die zweite Anschlussklemme (102) und Masse geschaltet ist; und/oder
- einen Transformator (20), der zwischen den Wechselrichter (13) und die zweite Schalterklemme (112) oder zwischen den Wechselrichter (13) und die zweite Anschlussklemme (102) geschaltet ist.

**Claims**

**1.** Method of controlling an uninterrupted power supply with the help of a system (10) for uninterrupted power supply, wherein the system (10) comprises

- a first connection terminal (101) which can be connected with an alternating current source;
- a second connection terminal (102) which can be connected with an alternating current load;
- a switch (11) comprising

    - a first switch terminal (111) connected with the first connection terminal (101);
    - a second switch terminal (112) connected with the second connection terminal (102);
    - first thyristor (113) connected between the switch terminals (111, 112); and
    - a second thyristor (114) connected between the switch terminals (111, 112) antiparallel to the first thyristor (113);

- an energy store (12); and
- an inverter (13) connected with the second connection terminal (102) and the energy store (12); wherein
- a switch current flowing through the switch (11) is detected;
- a first potential present at the first connection terminal (101) is detected; and
- in a first fault case in which the amount of the first potential drops so that the instantaneous value of the first potential infringes a first predetermined permissibility rule and the amount of the switch current rises so that the instantaneous value of the switch current infringes a second predetermined permissibility rule:

- a second potential present at the second switch terminal (102) is so set with the help of the inverter (13) that the switch current is driven to zero; and
- after setting of the second potential the switch current is checked in that:

- the amount of the switch current is detected up to a predetermined first checking instant lying after the setting of the second potential and is compared with a predetermined threshold value (SW2) and if this second threshold value (SW2) is exceeded a first check result is evaluated as positive and otherwise as negative;
- in the case of a positive first check result the second potential is reversed;
- in the case of a negative first check result the switch current is detected at a predetermined second checking instant lying at or after the first checking instant and is compared with zero and if there is departure from zero a second check result is evaluated as positive and otherwise as negative; and
- in the case of a positive second check result the second potential is reversed.

2. Method according to claim 1, wherein

- in the first fault case

- setting of the second potential is carried out in such a way that
$\text{sgn}(iS) \cdot v1 \leq \text{sgn}(iS) \cdot v2$ or $\text{sgn}(iS) \cdot v1 < \text{sgn}(iS) \cdot v2$
or $-v2/v1 \geq 1$ or $-v2/v1 > 1$,

wherein v1 is the instantaneous value of the first potential, v2 is the instantaneous value of the second potential and iS is the instantaneous value of the switch current.

3. Method according to claim 1 or according to the preceding claim, wherein

- the reversal is carried out in accordance with the following equation

$$v2(t2) = -A1 \cdot v2(t1)$$

in which $A1 \geq 1$ and $t2 > t1$,
wherein v2 is the instantaneous value of the second potential, t2 is an instant lying after the reversal, t1 is an instant lying in front of the reversal and A1 is a first proportioning factor.

4. Method according to claim 1 or according to one of the other preceding claims, wherein

- for the predetermined second check instant

$$PZ2 = T3 + A2 \cdot tq$$

in which $A2 \geq 1$,
wherein PZ2 is the second checking instant, T3 is the instant at which the second potential was set, A2 is a second proportioning factor and tq is the recovery time of the thyristors (113, 114).

5. Method according to claim 1 or according to any one of the other preceding claims, wherein

- after the reversal

$$v2 = \text{sgn}(iS) \cdot v0$$

in which $v0 > 0$,
wherein v0 is a predetermined default potential, v2 is the instantaneous value of the second potential and iS is the instantaneous value of the switch current.

6. Method according to the preceding claims, wherein

- the default potential is selected at least for a time in such a way that

$$v0 = A3 \cdot VWR$$

in which $0 < A3 \leq 1$,
wherein A3 is a third proportioning factor and VWR is the nominal potential of the inverter (13).

7. Method according to one of the two preceding claims, wherein

- the default potential is selected at least for a time in such a way that

$$v0 = v(iS),$$

wherein v(iS) is a function dependent on the switch current.

8. Method according to the preceding claim, wherein

- the function is selected in such a way that

$$v(iS) = L \cdot d|iS|/dt,$$

wherein L is the inductivity of the alternating current source and of the section of the system (10) between the first connection terminal (101) and the second switch terminal (112) and d|iS|/dt is the time derivative of the amount of the switch current.

9. Method according to one of the four preceding claims, wherein

- the default potential is determined at least for a time by a regulation managed through the switch current.

10. Method according to claim 1 or according to one of the other preceding claims, wherein

- monitoring is carried out as to whether the amount of the switch current after the reversal has dropped to zero;
- as soon as the amount of the switch current has dropped to zero a waiting time is waited out, for which

$$TW = A4 \cdot tq$$

in which A4 ≥ 1,
wherein TW is the waiting time, A4 is a fourth proportioning factor and tq is the recovery time of the thyristors (113, 114); and
- after expiry of the waiting time the second potential is set with the help of the inverter (13) in such a way as is required for an uninterrupted power supply and/or with the help of the inverter an active power such as required for an uninterrupted power supply and/or a reactive power such as required for an uninterrupted power supply is or are generated.

11. Method according to claim 1 or according to one of the other preceding claims, wherein

- in a second fault case in which the amount of the first potential drops and infringes a first predetermined permissibility rule and the amount of the switch current drops and/or

in a fluctuation case in which the amount of the first potential rises so that the instantaneous value of the first potential does not infringe a predetermined third permissibility rule or drops so that the instantaneous value of the first potential does not infringe the predetermined first permissibility rule

- then with the help of the inverter (13)

- the second potential such as required for an uninterrupted power supply is set; and/or
- an active power such as required for an uninterrupted power supply and/or a reactive power such as required for an uninterrupted power supply is or are generated.

12. Method according to claim 1 or according to one of the other preceding claims, wherein

- the second potential is detected; and
- the inverter (13) is controlled with the help of the second potential and/or in dependence on the second potential.

13. System (10) for uninterrupted power supply, wherein the system (10) comprises

- a first connection terminal (101) which can be connected with an alternating current source;
- a second connection terminal (102) which can be connected with an alternating current load;
- a switch (11) comprising

- a first switch terminal (111) connected with the first connection terminal (101);
- a second switch terminal (112) connected with the second connection terminal (102);
- first thyristor (113) connected between the switch terminals (111, 112); and
- a second thyristor (114) connected between the switch terminals (111, 112) antiparallel to the first thyristor (113);

- an energy store (12);
- an inverter (13) connected with the second connection terminal (102) and the energy store (12);
- a current sensor (14) which can detect a switch current flowing through the switch (11);
- a first voltage sensor (15) which can detect a first potential present at the first connection terminal (102); and
- a control device (16) coupled to the switch (11), the inverter (13) and the sensors (14, 15);
wherein the control device (16) is constructed in such a way that it

- can evaluate the switch current and the first potential; and

- can recognise a first fault case, in which the amount of the first potential drops so that the instantaneous value of the first potential infringes a first predetermined permissibility rule and the amount of the switch current rises so that the instantaneous value of the switch current infringes a second predetermined permissibility rule, and in that case it

- controls the inverter (13) in such a way that it generates a second potential which is present at the second switch terminal (102) and drives the switch current to zero; and
- after setting of the second potential checks the switch current in that it

- compares the amount of the switch current up to a predetermined first checking instant lying after the setting of the second potential with a predetermined threshold value (SW2) and if this threshold value (SW2) is exceeded evaluates a first check result as positive and otherwise as negative;
- in the case of a positive first check result reverses the second potential;
- in the case of a negative first check result compares the switch current at a predetermined second checking instant lying at or after the first checking instant with zero and if there is departure from zero evaluates a second check result as positive and otherwise as negative; and
- in the case of a positive second check result reverses the second potential.

14. System (10) according to claim 13, wherein

- the control device (16) is so constructed that in the first fault case it

- controls the inverter (13) in such a way that for the second potential
$sgn(iS) \cdot v1 \leq sgn(iS) \cdot v2$ or $sgn(iS) \cdot v1 < sgn(iS) \cdot v2$
or $-v2/v1 \geq 1$ or $-v2/v1 > 1$,

wherein v1 is the instantaneous value of the first potential, v2 is the instantaneous value of the second potential and iS is the instantaneous value of the switch current.

15. System (10) according to claim 13 or according to the preceding claim, comprising

- a coil (18) connected between the first connection terminal (101) and the first switch terminal (111) or between the second switch terminal (102) and the second connection terminal (112); and/or
- a capacitor (19) connected between the first connection terminal (101) and ground or between the first switch terminal (111) and ground or between the second switch terminal (112) and ground or between the second connection terminal (102) and ground; and/or
- a transformer (20) connected between the inverter (13) and the second switch terminal (112) or between the inverter (13) and the second connection terminal (102).

**Revendications**

1. Procédé de commande d'une alimentation en courant sans interruption à l'aide d'une installation (10) permettant une alimentation en courant sans interruption, cette installation (10) comprenant :

- une première borne de connexion (101) pouvant être reliée à une source de courant alternatif,
- une seconde borne de connexion (102) pouvant être reliée à un consommateur de courant alternatif,
- un commutateur (11) comprenant :

• une première borne de commutateur (111) reliée à la première borne de connexion (101),
• une seconde borne de commutateur (112) reliée à la seconde borne de connexion (102),
• un premier thyristor (113) branché entre les bornes du commutateur (111, 112),
• un second thyristor (114) branché en antiparallèle sur le premier thyristor (113) entre les bornes du commutateur (111, 112),

- un accumulateur d'énergie (12),
- un onduleur (13) relié à la seconde borne de connexion (102) et à l'accumulateur d'énergie (12),

selon lequel :

- on détecte le courant passant dans le commutateur (11),
- on détecte un premier potentiel appliqué sur la première borne de commutation (101),
- dans un premier cas de défaut dans lequel la valeur du premier potentiel chute de sorte que sa valeur instantanée ne respecte pas une première règle d'admissibilité prédéfinie, et la valeur du courant du commutateur augmente de sorte que sa valeur instantanée ne respecte pas une seconde règle d'admissibilité prédéfinie,

• à l'aide de l'onduleur (13) on règle un second potentiel appliqué sur la seconde borne du commutateur (102) de sorte que le courant du commutateur soit amené à zéro,
• après le réglage du second potentiel, on contrôle le courant du commutateur :

- en détectant la valeur du courant du commutateur jusqu'à un premier temps de contrôle prédéfini postérieur au réglage du second potentiel, en le comparant à une valeur de seuil (SW2) prédéfinie, et en cas de dépassement de cette valeur de seuil (SW2) en considérant le premier résultat de contrôle comme positif et sinon en le considérant comme négatif,
- en inversant le second potentiel en présence d'un premier résultat de contrôle positif,
- en détectant, en présence d'un premier résultat de contrôle négatif, le courant du commutateur à un second temps de contrôle prédéfini simultané ou postérieur au premier temps de contrôle, en le comparant à zéro, et en présence d'un écart par rapport à zéro, en considérant le second résultat de contrôle comme positif et sinon en le considérant comme négatif, et
- en inversant le second potentiel en présence d'un second résultat de contrôle positif.

2. Procédé conforme à la revendication 1, selon lequel :

- dans le premier cas de défaut,

• on effectue le réglage du second potentiel de façon à satisfaire aux formules :
sgn(iS) -v1≤sgn(iS) ·v2 ou sgn(iS) ·v1<sgn(iS)·v2
ou-v2/v1≥1 ou -v2/v1>1

dans laquelle v1 représente la valeur instantanée du premier potentiel, v2 représente la valeur instantanée du second potentiel et iS représente la valeur instantanée du courant du commutateur.

3. Procédé conforme à l'une des revendications 1 et 2 selon lequel :

- on effectue l'inversion conformément à la formule :
v2(t2)= -A1 v2(t1) avec A1≥1 et t2>t1
dans laquelle v2 représente la valeur instantanée du second potentiel, t2 représente un temps postérieur à l'inversion, t1 représente un temps antérieur à l'inversion et A1 représente un premier facteur proportionnel.

4. Procédé conforme à l'une des revendications 1 à 3, selon lequel le second temps de contrôle prédéfini, satisfait à la formule :

$$PZ2 = T3 + A2 \cdot tq$$

avec A2≥1
dans laquelle PZ2 représente le second temps de contrôle, T3 représente le temps auquel le second potentiel a été réglé, A2 représente un second facteur proportionnel et tq représente le temps de récupération des thyristors (113, 114).

5. Procédé conforme à l'une des revendications 1 à 4, selon lequel

- après l'inversion, on a la relation :

$$v2 = sgn(iS) \cdot v0$$

avec v0>0
dans laquelle v0 représente un potentiel de prescription donné, v2 représente la valeur instantanée du second potentiel et iS représente la valeur instantanée du courant du commutateur.

6. Procédé conforme à la revendication précédente, selon lequel :

- le potentiel de prescription est choisi au moins temporairement de façon à satisfaire à la relation :

$$v0 = A3 \cdot VWR$$

avec 0<A3≤1
dans laquelle A3 représente un troisième facteur proportionnel et VWR représente le potentiel nominal de l'onduleur (13).

7. Procédé conforme à l'une des revendications 2 à 6, selon lequel :
le potentiel de prescription est choisi au moins temporairement de façon à satisfaire à la relation :

$$v0 = v(iS),$$

dans laquelle v(iS) représente une fonction dépendant du courant du commutateur.

8. Procédé conforme à l'une des revendications précédentes, selon lequel :
   la fonction est choisie de façon à satisfaire à la relation :

$$v(iS)=L \cdot d|iS|/dt$$

   dans laquelle L représente l'inductance de la source de courant alternatif et du segment de l'installation (10) situé entre la première borne de connexion (101) et la seconde borne du commutateur (112) et d|iS|/dt représente la dérivée en fonction du temps de la valeur du courant du commutateur.

9. Procédé conforme à l'une des 4 revendications précédentes,
   selon lequel :
   le potentiel de prescription est déterminé au moins temporairement par une régulation guidée par le courant du commutateur.

10. Procédé conforme à l'une des revendications précédentes,
    selon lequel :

    - on contrôle si la valeur du courant du commutateur a chuté à zéro après l'inversion,
    - dès que la valeur du courant du commutateur a chuté à zéro, on attend un temps d'attente satisfaisant à la relation :

$$TW=A4 \cdot tq$$

    avec A4≥1
    dans laquelle TW représente le temps d'attente, A4 représente un quatrième facteur proportionnel et tq représente le temps de récupération des thyristors (113, 114),
    - après écoulement du temps d'attente, on règle à l'aide de l'onduleur (13) le second potentiel comme nécessaire pour permettre une alimentation en courant sans interruption, et/ou on produit à l'aide de l'onduleur la puissance active nécessaire pour permettre une alimentation en courant sans interruption et/ou la puissance réactive nécessaire pour permettre une alimentation en courant sans interruption.

11. Procédé conforme à l'une des revendications 1 à 10,

selon lequel :

    - dans un second cas de défaut dans lequel la valeur du premier potentiel chute et ne respecte pas la première règle d'admissibilité prédéfinie, et la valeur du courant du commutateur chute, et/ou dans un cas de fluctuation dans lequel la valeur du premier potentiel augmente de sorte que sa valeur instantanée respecte une troisième règle d'admissibilité prédéfinie ou chute de sorte que sa valeur instantanée respecte la première règle d'admissibilité prédéfinie,
    à l'aide de l'onduleur (13),
    - on règle le second potentiel comme nécessaire pour permettre une alimentation en courant sans interruption, et/ou
    - on produit la puissance active nécessaire pour permettre une alimentation en courant sans interruption et/ou la puissance réactive nécessaire pour permettre une alimentation en courant sans interruption.

12. Procédé conforme à l'une des revendications précédentes,
    selon lequel :

    - on détecte le second potentiel,
    - on commande l'onduleur (13) à l'aide du second potentiel et/ou en fonction du second potentiel.

13. Installation (10) destinée à permettre une alimentation en courant sans interruption comprenant :

    - une première borne de connexion (101) pouvant être reliée à une source de courant alternatif,
    - une seconde borne de connexion (102) pouvant être reliée à un consommateur de courant alternatif,
    - un commutateur (11) comprenant :

      • une première borne de commutateur (111) reliée à la première borne de connexion (101),
      • une seconde borne de commutateur (112) reliée à la seconde borne de connexion (102),
      • un premier thyristor (113) branché entre les bornes du commutateur (111, 112),
      • un second thyristor (114) branché en antiparallèle sur le premier thyristor (113) entre les bornes du commutateur (111, 112),

    - un accumulateur d'énergie (12),
    - un onduleur (13) relié à la seconde borne de connexion (102) et à l'accumulateur d'énergie (12),

- un détecteur de courant (14) susceptible de détecter le courant passant dans le commutateur (11),
- un premier détecteur de tension (15) susceptible de détecter un premier potentiel qui est appliqué sur la première borne de connexion (102),
- un dispositif de commande (16) qui est couplé au commutateur (11) à l'onduleur (13) et aux détecteurs (14, 15),

le dispositif de commande (16) étant réalisé de façon à pouvoir :

- évaluer le courant du commutateur et le premier potentiel,
- identifier un premier cas de défaut dans lequel la valeur du premier potentiel chute de façon telle que sa valeur instantanée ne respecte pas une première règle d'admissibilité prédéfinie, et que la valeur du courant du commutateur augmente de façon telle que sa valeur instantanée ne respecte pas une seconde règle d'admissibilité prédéfinie, et, dans ce cas à pouvoir :

  • commander l'onduleur (13) de sorte qu'il produise un second potentiel qui est appliqué sur la seconde borne du commutateur (102) et amène le courant du commutateur à zéro,
  • contrôler le courant du commutateur après le réglage du second potentiel :

- en comparant la valeur du courant du commutateur jusqu'à un premier temps de contrôle prédéfini postérieur au réglage du second potentiel avec une valeur de seuil prédéfinie (SW2), et en cas de dépassement de cette valeur de seuil (SW2) en considérant le premier résultat de contrôle comme positif et sinon en le considérant comme négatif,
- en présence d'un premier résultat de contrôle positif, en inversant le second potentiel,
- en présence d'un premier résultat de contrôle négatif, en comparant à zéro le courant du commutateur à un second temps de contrôle prédéfini simultané ou postérieur au premier temps de contrôle, et, en cas d'écart avec zéro en considérant le second résultat de contrôle comme positif et sinon en le considérant comme négatif, et
- en inversant le second potentiel en présence d'un second résultat de contrôle positif.

14. Installation (10) conforme à la revendication 13, dans laquelle :

- le dispositif de commande (16) est réalisé de sorte que, dans le premier cas de défaut,

- il commande l'onduleur (13) de sorte que le second potentiel satisfasse aux formules :
  sgn(iS)       -v1≤sgn(iS)·v2       ou sgn(iS)·v1<sgn(iS)·v2
  ou -v2/v1≥1 ou -v2/v1>1 dans lesquelles v1 représente la valeur instantanée du premier potentiel, v2 représente la valeur instantanée du second potentiel et iS représente la valeur instantanée du courant du commutateur.

15. Installation (10) conforme à l'une des revendications 13 et 14 comprenant :

- une bobine (18) branchée entre la première borne de connexion (101) et la première borne du commutateur (111) ou entre la seconde borne de connexion (102) et la seconde borne du commutateur (112), et/ou
- un condensateur (19) branché entre la première borne de connexion (101) et la masse ou entre la première borne du commutateur (111) et la masse ou entre la seconde borne du commutateur (112) et la masse ou entre la seconde borne de connexion (102) et la masse, et/ou
- un transformateur (20) branché entre l'onduleur (13) et la première borne du commutateur (112) ou entre l'onduleur (13) et la seconde borne de connexion (102).

## FIG. 1

## FIG. 2

**FIG. 3**

FIG. 4)

a)

b)

## FIG 5)

**a)**

**b)**

**EP 3 291 411 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1160965 B1
- EP 1276202 B1
- US 5210685 A
- US 4782241 A
- JP 2003259567 A